# EUROPEAN PATENT APPLICATION

(11) **EP 4 831 682 A1**
(43) Date of publication of application: **28.10.2026**
(21) Application number: 24924568.9
(22) Date of filing: 10.12.2024
(51) Int. Cl.: G01S 7/481, G01J 1/04, G02B 1/118, H10F 55/00

(54) **INFRARED SENSOR COVER AND INFRARED SENSOR**

(30) Priority: 13.02.2024 JP 2024019704
(71) Applicant: Dexerials Corporation, Shimotsuke-shi, Tochigi 323-0194 (JP)
(72) Inventor: KIKUCHI, Masanao, Shimotsuke-shi, Tochigi 323-0194 (JP); KANASUGI, Shunsuke, Shimotsuke-shi, Tochigi 323-0194 (JP)
(74) Representative: Müller-Boré & Partner Patentanwälte PartG mbB
(86) International application number: PCT/JP2024/043593
(87) International publication number: WO 2025/173365

(57) **Abstract**

An infrared sensor cover 7 that covers an infrared sensor configured to measure distance to a measurement target using an infrared ray includes a base member 10, and a micro concave-convex structure 11 that is provided on at least one surface of the base member 19. The micro concave-convex structure 11 includes a plurality of convexities 12 disposed at pitch P less than or equal to a wavelength λ of the infrared ray. The infrared sensor cover 7 is disposed on the infrared sensor to allow the infrared ray to be incident upon the infrared sensor cover 7 from a direction inclined with respect to the surface of the infrared sensor cover 7. A ratio (H/λ) of height H of each of the convexities 12 to the wavelength λ is greater than or equal to 0.5.

## Description

### Technical Field

The present invention relates to an infrared sensor cover and an infrared sensor.

This application claims the benefit of priority from Japanese Patent Application No. 2024-019704 filed on February 13, 2024, the content of which is incorporated herein.

### Background Art

In recent years, the automotive field and the like have seen the widespread use of technology that detects the distance and the relative speed between a vehicle and an obstacle (measurement target) including a preceding vehicle, a pedestrian, and the like by irradiating the area around the vehicle with infrared rays (particularly near-infrared rays) from an infrared sensor and detecting the infrared rays hitting against and reflected by the obstacle. For example, optical distance measurement apparatuses have been used that use remote sensing technology such as LiDAR (Light Detection and Ranging) which uses infrared rays.

Infrared sensors are each typically provided with a cover around the sensor main unit to protect the sensor main unit. Glass or resin is used as the material of the infrared sensor cover in most cases. The simple use of glass or resin, however, leads to the insufficient transmittance of the cover for infrared rays because infrared rays are reflected on a surface of the cover and may cause the infrared sensor to have reduced performance. For example, Patent Literature 1 therefore proposes an infrared sensor cover provided with an antireflection layer on a surface of the cover for preventing infrared rays from being reflected.

### Citation List

### Patent Literature

Patent Literature 1: JP 2018-124279A

### Summary of Invention

### Technical Problem

In a case where infrared rays are incident upon the surface of the cover from an oblique direction (referred to as "oblique incidence" below), it is not, however, possible for even the conventional infrared sensor cover described in Patent Literature 1 above to sufficiently reduce the reflection of the obliquely incident infrared rays and there is a problem that the transmittance for the infrared rays is reduced. In particular, in a system that performs scanning with infrared rays at a large angle (e.g., 60°) and detects the infrared rays using the infrared sensor, the transmittance for infrared rays obliquely incident upon a surface of the cover is significantly degraded. This is a factor for reduction in the detection accuracy of the infrared sensor. It has been thus conventionally required to exhibit superior antireflection performance for infrared rays (particularly near-infrared rays) obliquely incident within a wide range of incidence angles (e.g., -60° to +60°) including large-angle incidence and increase the detection accuracy of the infrared sensor.

Accordingly, the present invention has been devised in view of the problem. An object of the present invention is to provide an infrared sensor cover and an infrared sensor that are each make it possible to increase antireflection performance for infrared rays obliquely incident within a wide range of incidence angles including large-angle incidence.

### Solution to Problem

To solve the problem, according to an aspect of the present invention, there is provided an infrared sensor cover that covers an infrared sensor configured to measure distance to a measurement target using an infrared ray. The infrared sensor cover includes:
a base member; and
a micro concave-convex structure that is provided on at least one surface of the base member. The micro concave-convex structure includes a plurality of convexities disposed at pitch P less than or equal to a wavelength λ of the infrared ray.

The infrared sensor cover is disposed on the infrared sensor to allow the infrared ray to be incident upon the infrared sensor cover from a direction inclined with respect to the surface of the infrared sensor cover.

A ratio (H/λ) of height H of each of the convexities to the wavelength λ is greater than or equal to 0.5.

A ratio (P/λ) of the pitch P of the convexities to the wavelength λ may be less than or equal to 0.5.

A ratio (H/P) of the height H to the pitch P of the convexities may be less than or equal to 3.

The infrared ray may be a near-infrared ray the wavelength λ of which is greater than or equal to 800 nm and less than or equal to 2500 nm.

A shape of the convexity may be substantially an elliptical-cone shape, an elliptical-cone frustum shape, or a bell shape or a dome shape a planar shape of which is an elliptical shape.

When the infrared ray is incident upon the surface of the infrared sensor cover at an incidence angle of greater than 0° and less than or equal to 60°, reflectance for the infrared ray may be less than or equal to 3%.

In addition, to solve the problem, according to another aspect of the present invention, there is provided an infrared sensor including:
the infrared sensor cover;
a light irradiation device configured to irradiate a measurement target with infrared laser light through the infrared sensor cover; and
a light detection device configured to detect, through the infrared sensor cover, reflected light of the infrared laser light reflected by the measurement target.

### Advantageous Effects of Invention

The present invention makes it possible to increase antireflection performance for infrared rays obliquely incident within a wide range of incidence angles including large-angle incidence.

### Brief Description of Drawings

[FIG. 1] FIG. 1 is a schematic diagram illustrating an overall configuration of an optical distance measurement apparatus according to a first embodiment of the present invention.
[FIG. 2] FIG. 2 is a cross-sectional view of an infrared sensor cover according to the embodiment.
[FIG. 3] FIG. 3 is a cross-sectional view of an infrared sensor cover according to a modification example of the embodiment.
[FIG. 4] FIG. 4 is a plan view of disposition of a plurality of convexities of a micro concave-convex structure according to the embodiment.
[FIG. 5] FIG. 5 is a plan view of disposition of a plurality of convexities of a micro concave-convex structure according to a modification example of the embodiment.
[FIG. 6] FIG. 6 is a perspective view of an example of a convexity of the micro concave-convex structure according to the embodiment.
[FIG. 7] FIG. 7 is a perspective view of an example of the convexity of the micro concave-convex structure according to the embodiment.
[FIG. 8] FIG. 8 is a perspective view of an example of the convexity of the micro concave-convex structure according to the embodiment.
[FIG. 9] FIG. 9 is a partially enlarged sectional view of the micro concave-convex structure according to the embodiment.
[FIG. 10] FIG. 10 is a graph illustrating a result obtained by simulating a relationship between height of the convexity of the micro concave-convex structure according to the embodiment, an incidence angle, and reflectance.
[FIG. 11] FIG. 11 is a schematic perspective view of a master according to the embodiment.
[FIG. 12] FIG. 12 is a schematic diagram illustrating a configuration of a transfer device that manufactures a transfer object using the master according to the embodiment.
[FIG. 13] FIG. 13 is an explanatory diagram illustrating a schematic configuration of an exposure device according to the embodiment.
[FIG. 14] FIG. 14 is a schematic diagram illustrating reflectance and a method for measuring diffracted light according to an example.

### Description of Embodiments

Hereinafter, an embodiment of the present invention will be described in detail with reference to the appended drawings. Specific dimensions, materials, numerical values, and the like indicated in this embodiment are merely examples for facilitating the understanding of the invention and are not intended to limit the present invention unless otherwise specified. Note that, in the present specification and the drawings, elements having substantially the same function and configuration are denoted with the same reference numerals to omit duplicate explanation. In addition, elements not directly pertinent to the present invention are not also illustrated.

### [1. Overall Configuration of Optical Distance Measurement Apparatus]

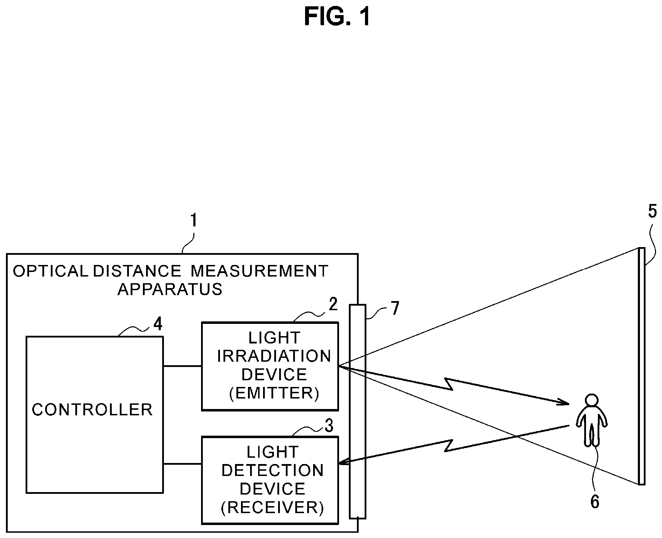

First, the overall configuration of an optical distance measurement apparatus 1 including an infrared sensor according to a first embodiment of the present invention will be described with reference to FIG. 1. FIG. 1 is a schematic diagram illustrating the overall configuration of the optical distance measurement apparatus 1 according to the present embodiment.

As illustrated in FIG. 1, the optical distance measurement apparatus 1 including the infrared sensor according to the present embodiment is an apparatus that irradiates a distance measurement target area 5 with light and detects light reflected by a measurement target 6 to measure the distance to the measurement target 6, the direction of the measurement target 6, the size of the measurement target 6, the shape of the measurement target 6, the relative speed of the measurement target 6, and the like. The optical distance measurement apparatus 1 includes, for example, a distance measurement sensor (infrared sensor) that uses remote sensing technology such as LiDAR. It is preferable that a distance measurement method by the optical distance measurement apparatus 1 be, for example, a TOF method in which the optical distance measurement apparatus 1 measures the time of flight (TOF: Time Of Flight) to calculate the distance to the measurement target 6. In addition, various distance measurement methods such as a triangulation method may be, however, used. The time of flight (TOF) is the round-trip time elapsed from the emission of irradiation light to the reception of reflected light by the optical distance measurement apparatus 1.

The optical distance measurement apparatus 1 according to the present embodiment is applicable to various technical fields that use remote sensing. For example, the optical distance measurement apparatus 1 is applicable to automated driving technology, ADAS (Advanced Driver-Assistance Systems: advanced driving assistant systems), or a traffic regulation radar apparatus in the automotive field, location surveying, location surveying with an aircraft/artificial satellite, a cleaner robot, or 3D-mapping measurement by various terminal apparatuses (such as a smartphone, smart glasses, a smart watch, a personal computer, and a tablet PC) that use technology such as AR (augmented reality)/MR (mixed reality)/VR (virtual reality) in the construction field, or various kinds of measurement, military application, or the like in geology/seismology/atmospheric physics/oceanography, and the like.

The optical distance measurement apparatus 1 according to the present embodiment is mounted, for example, on a vehicle such as an automobile, a bus, a track, or a motorcycle and is favorably applied to automated driving technology, ADAS, or the like. In this case, it is possible for the optical distance measurement apparatus 1 to measure the distance to the measurement target 6 present around the vehicle, in particular, the measurement target 6 present in the space ahead of the vehicle, and the direction of the measurement target 6 and create 3D mapping. This example is not, however, limitative. It is possible to mount the optical distance measurement apparatus 1 on various products in the various technical fields.

As illustrated in FIG. 1, the optical distance measurement apparatus 1 according to the present embodiment includes a light irradiation device 2 (emitter), a light detection device 3 (receiver), and a controller 4. This optical distance measurement apparatus 1 is an example of an infrared sensor that measures the distance to a measurement target or the like using infrared rays. The optical distance measurement apparatus 1 functions as a distance measurement sensor such as an LiDAR.

The light irradiation device 2 is a device (emitter) for irradiating the distance measurement target area 5 with light (infrared rays). The light irradiation device 2 irradiates the distance measurement target area 5 with infrared rays emitted from a light source. The infrared rays radiated from the light irradiation device 2 are laser light having an infrared wavelength band (wavelength: about 700 nm to 1000 µm). For example, laser light having a wavelength band such as a near-infrared wavelength band (wavelength: about 700 nm to 2500 nm), a mid-infrared wavelength band (wavelength: about 2.5 µm to 4 µm), or a far-infrared wavelength band (wavelength: about 4 µm to 1000 µm) is usable as the infrared laser light. It is preferable that the infrared laser light be laser light having a near-infrared wavelength band (e.g., 800 nm to 2500 nm, preferably 850 nm to 1550 nm) invisible to human eyes. It is preferable that the light source included in the light irradiation device 2 be a laser light source such as a semiconductor laser which emits infrared laser light in the wavelength band.

The light irradiation device 2 includes, for example, a light source including a light emitting element that emits infrared laser light, an optical element that diffuses the laser light, a housing, and the like (that are all unillustrated). The light irradiation device 2 emits pulsed laser light from the light source, diffuses the laser light using the optical element, and irradiates the distance measurement target area 5 with the diffused light (irradiation light). Alternatively, the light irradiation device 2 may radiate laser light to scan the distance measurement target area 5 at a large angle by changing the irradiation direction of the pulsed laser light emitted from the light source.

The light detection device 3 is a device (receiver) for detecting infrared light (reflected light) radiated from the light irradiation device 2 and reflected by the measurement target 6. The light detection device 3 includes, for example, an optical filter, a light receiving unit including a light receiving element, and the like (that are all unillustrated). The optical filter cuts light (e.g., sunlight, illumination light, or the like) other than the reflected light reflected by the measurement target 6 as noise and transmits only light corresponding to the wavelength of the infrared laser light emitted from the light irradiation device 2. This allows the light receiving element to have higher detection sensitivity to the reflected light. The light receiving element includes a photoelectric conversion element that receives incident reflected light and generates a voltage. The light receiving element includes, for example, an image sensor such as a CMOS (Complementary Metal Oxide Semiconductor) sensor or a CCD (Charge Coupled Device) sensor. The light receiving unit receives the reflected light from the measurement target 6 using, for example, a plurality of light receiving elements two-dimensionally arrayed on the light receiving surface, converts the light reception intensity at each of the pixel positions on the light receiving surface into an electric signal, and outputs the electric signal to the controller 4.

The controller 4 is an example of a control unit that controls the operations of the light irradiation device 2, the light detection device 3, and the other various devices included in the optical distance measurement apparatus 1. The controller 4 includes, for example, a processor, a memory, an input device, an output device, a communication device, and the like (that are all unillustrated).

The processor includes, for example, a CPU (Central Processing Unit) or another microprocessor. The processor executes a program stored in a memory or another storage medium. This causes various kinds of processing of the optical distance measurement apparatus 1 to be executed and it is possible to implement various functions defined by the program.

The memory is a storage medium that stores a program and other various kinds of data. The memory includes, for example, a RAM (Random Access Memory), a ROM (Read Only Memory), and the like. The ROM is a non-volatile memory that stores a program to be used by the processor, data for bringing the program into operation, and the like. The RAM is a volatile memory that temporarily stores data such as a variable to be used for processing to be executed by the processor, an arithmetic parameter, and an arithmetic result. The program stored in the ROM is read into the RAM and executed by the processor such as a CPU.

The controller 4 controls the light irradiation device 2 and the light detection device 3 to execute a distance measurement operation by the optical distance measurement apparatus 1. For example, the controller 4 creates three-dimensional mapping while three-dimensionally scanning the distance measurement target area 5 by repeatedly radiating laser light using the light irradiation device 2 and detecting reflected light using the light detection device 3. In this case, the controller 4 calculates the distance, the direction from the optical distance measurement apparatus 1 to the measurement target 6, the direction of the measurement target 6, the relative speed of the measurement target 6, and the like on the basis of the time difference (i.e., the time of flight: TOF) between the emission timing of laser light by the light irradiation device 2 and the detection timing of reflected light by the light detection device 3.

In this manner, the optical distance measurement apparatus 1 creates three-dimensional mapping indicating the distance to the measurement target 6 present in the distance measurement target area 5 and the direction of the measurement target 6 by scanning the distance measurement target area 5 with laser light. To this end, the optical distance measurement apparatus 1 is required to radiate laser light within as wide a range of angles (i.e., field of view (FOV: Field of View)) as possible. Laser light emitted from the light source of the light irradiation device 2 does not expand so much and the laser light as emitted thus results in a narrow field of view for the distance measurement sensor. It is therefore preferable to diffuse the laser light by using a diffuser plate or the like, irradiate the distance measurement target area 5 with the diffused light in a wide field of view, and increase the irradiation area.

The diffuser plate for diffusing laser light includes a microlens array. It is possible to obtain a desired diffusion angle (i.e., field of view) by changing the shape of a microlens. However, as described above, a distance measurement sensor such as a TOF sensor has a trade-off relationship between the size of a laser light irradiation area (the range of the distance measurement target area 5 in the horizontal direction and the vertical direction) and laser light irradiation distance (measurable distance). It is thus preferable to balance them and determine the size of the irradiation area.

In this manner, to scan the wide distance measurement target area 5 with infrared laser light, the optical distance measurement apparatus 1 according to the present embodiment radiates infrared laser light in the inclination direction of the optical distance measurement apparatus 1 in addition to the front direction and receives reflected light of the laser light reflected by the measurement target 6 even from the inclination direction.

### [2. Overview of Infrared Sensor Cover]

In addition, as illustrated in FIG. 1, the optical distance measurement apparatus 1 (infrared sensor) according to the present embodiment includes an infrared sensor cover 7. The infrared sensor cover 7 (also referred to simply as the "cover 7" below in some cases) is a cover for protecting the sensor main unit of the infrared sensor. The infrared sensor cover 7 is provided to cover the sensor main unit. Here, the sensor main unit of the infrared sensor is a sensor group including, for example, the light irradiation device 2 (emitter), the light detection device 3 (receiver), and the controller 4.

The cover 7 is disposed to cover both or one of the light emitting surface and the light receiving surface of the sensor main unit of the infrared sensor. For example, the cover 7 illustrated in FIG. 1 is a member shaped like a flat plate. The cover 7 is provided to an opening formed on one side surface of the housing of the optical distance measurement apparatus 1 (infrared sensor). The cover 7 is disposed to cover both the light emitting surface of the light irradiation device 2 and the light receiving surface of the light detection device 3.

Note that the cover 7 is not limited to the shape or the disposition in the example of FIG. 1. For example, the cover 7 may include a cover shaped like a curved plate instead of a flat plate. In addition, one infrared sensor may be provided with the plurality of covers 7 and the light emitting surface of the light irradiation device 2 and the light receiving surface of the light detection device 3 may be individually covered with the plurality of respective covers 7.

The cover 7 is formed using material that allows infrared rays used in the infrared sensor to pass through the cover 7, in particular, material that allows near-infrared rays to favorably pass through the cover 7. This allows infrared laser light radiated from the light irradiation device 2 of the infrared sensor to pass through the cover 7 from the inner side to the outer side of the cover 7. In addition, it is also possible for reflected light of laser light reflected by the measurement target 6 to pass through the cover 7 from the outer side to the inner side of the cover 7.

In this manner, in the optical distance measurement apparatus 1 (infrared sensor) according to the present embodiment, the light irradiation device 2 and the light detection device 3 that are a sensor main unit are covered with the cover 7. The light irradiation device 2 then radiates infrared laser light in the front direction and the inclination direction of the optical distance measurement apparatus 1 through the cover 7 to scan the whole of the distance measurement target area 5 including the measurement target 6. Meanwhile, when the radiated infrared laser light is reflected by the measurement target 6 and comes back from the front direction and the inclination direction of the optical distance measurement apparatus 1, the light detection device 3 receives and detects the reflected light through the cover 7.

As described above, infrared laser light and reflected light thereof are incident upon the cover 7 of the infrared sensor according to the present embodiment from both the inner side and the outer side of the cover 7. Furthermore, in the optical distance measurement apparatus 1 (infrared sensor) according to the present embodiment, the cover 7 is disposed to allow infrared laser light and reflected light thereof to be incident at a large incidence angle θ from not only a direction (normal direction) vertical to a surface of the cover 7, but also a direction (inclination direction) inclined with respect to the surface. Here, the range of the incidence angles θ of infrared laser light and reflected light thereof that are obliquely incident upon the cover 7 depends on the specifications, the applications, or the like of the optical distance measurement apparatus 1 (infrared sensor). For example, the range of the incidence angles θ is -45° to +45°, -60° to +60°, -75° to +75°, or the like and the range of the incidence angles θ is an extremely wide range of large angles in some cases. Additionally, in a case where the incidence angle θ has a positive value (e.g., +45°) in the present specification, this means that the oblique-incidence light is incident from a direction inclined to one side (the negative direction of the X axis) with respect to the normal direction (Z direction) of a surface of the cover 7. In contrast, in a case where the incidence angle θ has a negative value (e.g., -45°), this means that the oblique-incidence light is incident from a direction inclined to the other side (the positive direction of the X axis) with respect to the normal direction (Z direction) of the surface of the cover 7.

In a case where infrared laser light having a longer wavelength than that of visible light is obliquely incident upon the cover of the infrared sensor at the large (e.g., about 60°) incidence angle θ in this manner, a conventional cover fails to sufficiently reduce the reflection of the obliquely incident infrared rays. The conventional cover therefore has a problem that the infrared sensor has reduced detection accuracy because the reflectance for the obliquely incident infrared rays increases, for example, to 3% or more and the transmittance for the obliquely incident infrared rays is reduced, for example, to less than 97%.

Accordingly, an object of the infrared sensor and the cover 7 according to the present embodiment is to significantly increase the antireflection performance of the cover 7 for infrared rays (particularly near-infrared rays) that are obliquely incident within a wide range of incidence angles (e.g., -60° or more and +60° or less) including normal incidence and large-angle incidence and increase the detection accuracy of the infrared sensor through the cover 7. A surface of the cover 7 according to the present embodiment therefore includes, as an antireflection layer, a micro concave-convex structure corresponding to infrared rays that are obliquely incident at a large angle. Features of the micro concave-convex structure included in the cover 7 according to the present embodiment will be described in detail below.

### [3. Configuration of Infrared Sensor Cover]

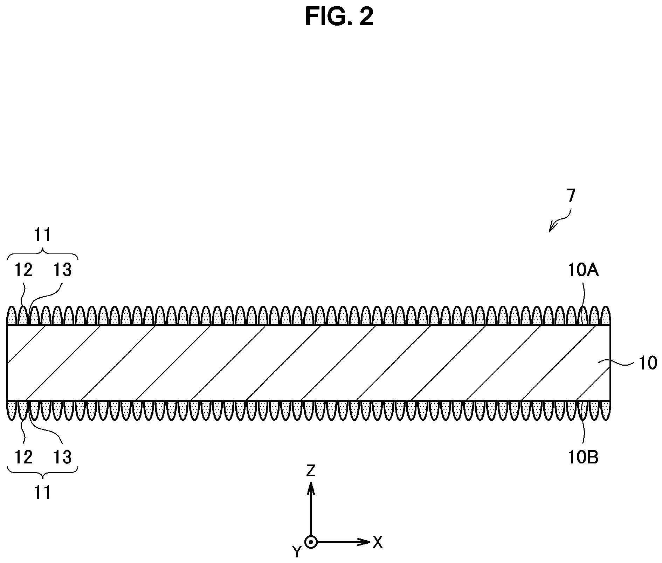

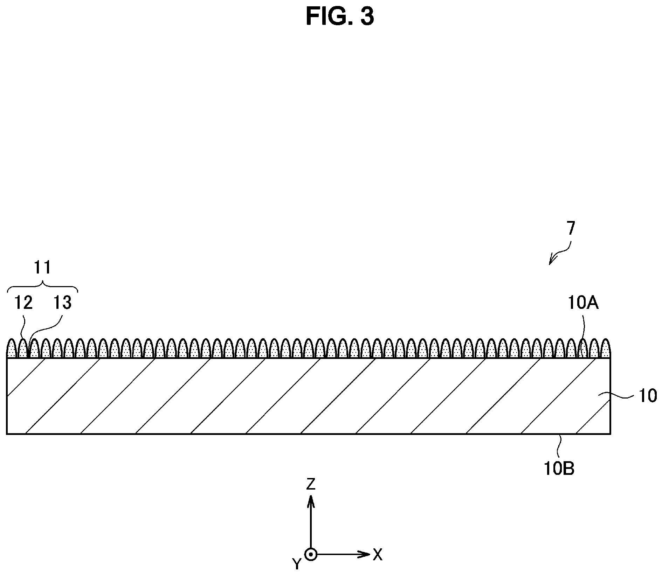

Next, the configuration of the infrared sensor cover 7 according to the present embodiment will be described with reference to FIGS. 2 to 3. FIG. 2 is a cross-sectional view of the infrared sensor cover 7 according to the present embodiment. FIG. 3 is a cross-sectional view of the infrared sensor cover 7 according to a modification example of the present embodiment.

As illustrated in FIG. 2, the infrared sensor cover 7 includes a base member 10 and a micro concave-convex structure 11.

The base member 10 is a base member included in the main body of the cover 7. The base member 10 is a plate-shaped or sheet-shaped base member. The base member 10 is shaped, for example, like a flat plate, but may be shaped like a curved plate. It is is sufficient if the base member 10 is shaped like a plate appropriate for installing the cover 7 in the infrared sensor. The thickness of the base member 10 is not limited in particular. The thickness of the base member 10 may be adjusted as appropriate depending on a wavelength λ of infrared rays used in the infrared sensor, the application of the cover 7, or the like.

The base member 10 is formed using, for example, inorganic material such as glass or organic material such as resin. It is preferable that the material of the base member 10 be a resin (e.g., a thermoplastic resin, a photocurable resin, or the like) superior in transmissivity for infrared rays used in the infrared sensor. In particular, a resin superior in transmissivity for near-infrared rays is preferable. Examples of such resins include polymethyl methacrylate, polycarbonate, A-PET, a cycloolefin copolymer, a cycloolefin polymer, and the like. In addition, the base member 10 may be formed using an inorganic material superior in transmissivity for infrared rays. Examples of such an inorganic material include a silicon-based material, more specifically glass or the like. It is preferable that the base member 10 have a transmittance or 97% or more for infrared rays.

The micro concave-convex structure 11 is a micro concave-convex structure (moth-eye structure) that is formed on a surface of the base member 10. The micro concave-convex structure 11 has a function (antireflection function) of preventing infrared rays from being reflected on a surface of the cover 7.

As illustrated in FIGS. 2 and 3, the micro concave-convex structure 11 is provided on at least one surface of the base member 10. In the example of FIG. 2, the micro concave-convex structures 11 are provided on both surfaces (i.e., a front surface 10A and a back surface 10B) of the base member 10. In contrast, in the example of FIG. 3, the micro concave-convex structure 11 is provided on only one surface (i.e., front surface 10A) of the base member 10.

The micro concave-convex structure 11 includes a plurality of convexities 12 and a plurality of concavities 13. Each of the convexities 12 is a protruding structural body that projects from a surface of the base member 10 in the vertical direction. Each of the concavities 13 is a recessed portion between the adjacent convexities 12 and 12. The size and array pitch P of the convexities 12 are, for example, about several tens of nm to about several tens of µm, preferably about several hundred nm to about several µm (on the order of nanometers). The size and the array pitch P are extremely minute.

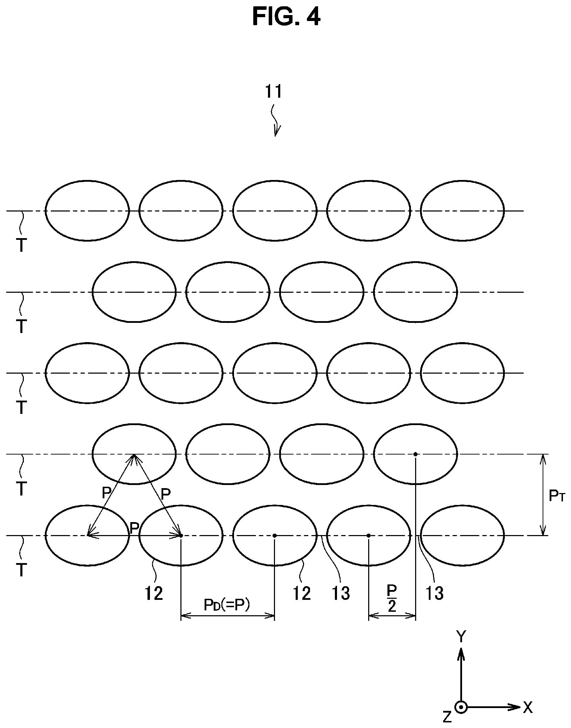

To attain an antireflection function for infrared rays using the micro concave-convex structure 11, the convexities 12 of the micro concave-convex structure 11 are disposed on a surface of the base member 10 at the pitch P less than or equal to the wavelength λ of infrared rays used in the infrared sensor. In other words, the pitch P of the convexities 12 of the micro concave-convex structure 11 is pitch less than or equal to the wavelength λ of infrared rays used in the infrared sensor. For example, in a case where infrared rays used in the infrared sensor are near-infrared rays and the wavelength λ of these near-infrared rays is within a range of 800 nm or more and 2500 nm or less, it is preferable that the pitch P of the convexities 12 be less than or equal to the wavelength λ of the near-infrared rays. Note that the pitch P is the distance (i.e., the distance between the center points of the two convexities 12 in a planar shape) between the peaks of the two adjacent convexities 12 (see FIG. 4).

In the present embodiment, the micro concave-convex structure 11 including the plurality of convexities 12 arrayed at the minute pitch P like this is provided on a surface of the cover 7 to allow a moth-eye structure superior in antireflection performance for infrared rays to be formed on the surface of the cover 7. This forms an effective refractive index gradient between air and the material of the cover 7. Light (infrared rays) that is incident on the surface of the cover 7 and passes through the micro concave-convex structure 11 is therefore refracted gently and surface reflection is reduced.

As illustrated in FIG. 2, the micro concave-convex structures 11 formed on both surfaces (the front surface 10A and the back surface 10B) of the base member 10 make it possible to reduce the reflection of infrared rays on the front surface 10A and the back surface 10B of the base member 10. It is thus preferable to reduce the reflection of infrared rays (irradiation light and reflected light) incident upon both surfaces of the cover 7 by providing the micro concave-convex structures 11 on both surfaces (the front surface 10A and the back surface 10B) of the base member 10 of the cover 7 as illustrated in FIG. 2 in a case where the infrared rays are incident upon the cover 7 from both directions of the front surface side and the back surface side of the cover 7 in the infrared sensor as illustrated in FIG. 1.

In addition, as illustrated in FIG. 3, the micro concave-convex structure 11 may be formed on one surface (front surface 10A) of the base member 10 alone and the micro concave-convex structure 11 may be prevented from being formed on the other surface (back surface 10B). This also makes it possible to reduce the reflection of infrared rays on the front surface 10A of the base member 10 and reduce the reflection of infrared rays on one surface of the cover 7. Additionally, although not illustrated, the micro concave-convex structure 11 may be provided on one surface of the base member 10 and an antireflection film having a multi-layer structure may be provided on the other surface.

### [4. Configuration of Micro Concave-convex Structure]

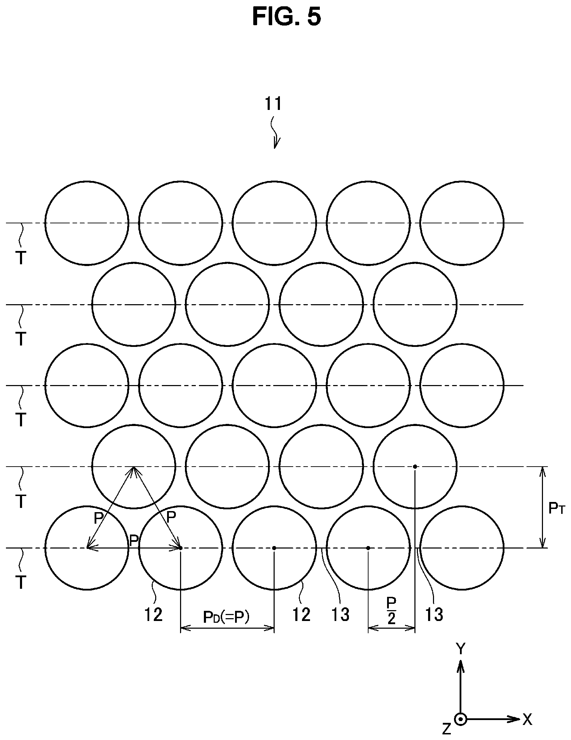

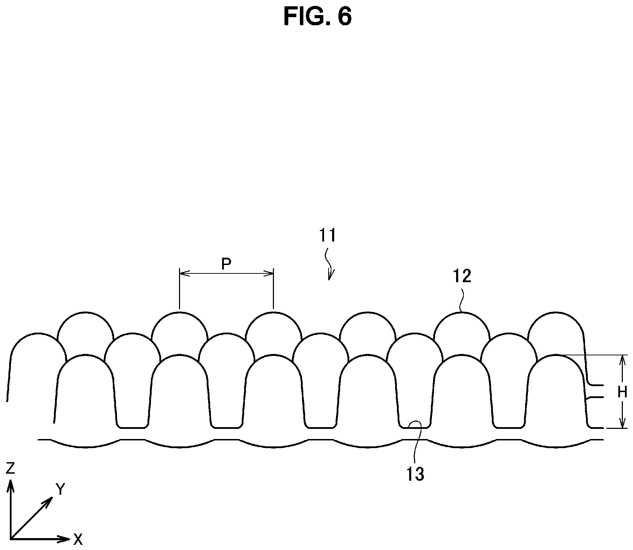

Next, the configuration of the micro concave-convex structure 11 according to the present embodiment will be described in more detail with reference to FIGS. 4 to 8. FIG. 4 is a plan view of the disposition of the plurality of convexities 12 of the micro concave-convex structure 11 according to the present embodiment. FIG. 5 is a plan view of the disposition of the plurality of convexities 12 of the micro concave-convex structure 11 according to a modification example of the present embodiment. Each of FIGS. 6 to 8 is a perspective view of an example of the convexities 12 of the micro concave-convex structure 11 according to the present embodiment.

The plurality of convexities 12 of the micro concave-convex structure 11 may be regularly or irregularly disposed on a surface of the base member 10. FIG. 4 illustrates an example in which the plurality of convexities 12 each having an elliptical planar shape is regularly disposed. FIG. 5 illustrates an example in which the plurality of convexities 12 each having a circular planar shape is regularly disposed.

As illustrated in FIGS. 4 and 5, in the micro concave-convex structure 11 according to the present embodiment, the plurality of convexities 12 is regularly arrayed on a surface of the base member 10 (on an XY plane) in a hexagonal lattice shape. The plurality of convexities 12 is disposed along a plurality of tracks T at predetermined intervals (dot pitch P_{D}). The plurality of tracks T extends in the X direction. Each of the tracks T is an imaginary line indicating the array direction of the convexities 12. The plurality of tracks T is parallel with each other and is disposed at predetermined intervals (track pitch P_{T}) in the Y direction.

Here, the dot pitch P_{D} is the pitch of the convexities 12 along a track direction (X direction) that is the length direction of each of the tracks T. That is, the dot pitch P_{D} is the distance between the peaks of the two convexities 12 adjacent in the track direction (X direction). The dot pitch P_{D} is equal to the pitch P (P_{D} = P). Meanwhile, the track pitch P_{T} is the pitch of the convexities 12 along a track vertical direction (Y direction) that is a direction vertical to the track direction (X direction). The track pitch P_{T} is equal to the interval between the two tracks T and T adjacent in the track vertical direction (Y direction). As illustrated in FIG. 4, in a case where the convexities 12 are arrayed in a hexagonal lattice shape, the track pitch P_{T} has a smaller value than that of the pitch P (P_{T} < P). Additionally, although not illustrated, in a case where the convexities 12 are arrayed in a square lattice shape, the dot pitch P_{D} and the track pitch P_{T} each have a value equal to that of the pitch P (P_{D} = P_{T} = P).

As illustrated in FIGS. 4 and 5, the plurality of convexities 12 is regularly arrayed along the plurality of tracks T in a hexagonal lattice shape. The dot pitch P_{D} therefore has a substantially constant value and the track pitch P_{T} also has a substantially constant value between any two extracted convexities 12. In addition, a comparison between the two rows of convexities 12 disposed along the two respective tracks T and T adjacent in the Y direction shows that the disposition of the convexities 12 in one row in the X direction is shifted from that of the convexities 12 in the other row in the X direction by one half of the dot pitch P_{D} (P_{D}/2). Disposing the convexities 12 in the respective tracks T such that the convexities 12 are shifted in the X direction by P_{D}/2 in this manner causes the plurality of convexities 12 to be regularly disposed in a hexagonal lattice shape in the whole of the micro concave-convex structure 11. This close-packs the convexities 12 on a surface of the base member 10 and allows the convexities 12 to be packed at a higher packing ratio. It is thus possible to increase the antireflection performance of the micro concave-convex structure 11 on the surface of the base member 10 per unit area.

Note that the packing ratio is the proportion of area occupied by the plurality of convexities 12 on a surface (XY plane) of the base member 10. In a case where a surface (flat surface) of the base member 10 is filled with the plurality of convexities 12 and there is no flat surface between the convexities 12 and 12, the packing ratio is 100%. In contrast, in a case where the plurality of convexities 12 is disposed on a surface (flat surface) of the base member 10 with some gaps left in between and there is a flat surface at the concavity 13 between the plurality of convexities 12 and 12 as illustrated in FIG. 4, the packing ratio is less than 100%. Even in a case where the plurality of convexities 12 is disposed with gaps left in between as illustrated in FIG. 4, it is preferable to make the gaps as small as possible and increase the packing ratio, for example, to 80% or more, preferably 90% or more. This makes it possible to increase the antireflection performance of the micro concave-convex structure 11.

In addition, it is preferable that the micro concave-convex structure 11 have a hexagonal lattice array in which the plurality of convexities 12 is arrayed at the peaks and the center of the hexagon on a surface of the base member 10 as illustrated in FIGS. 4 and 5. This makes it possible to dispose a large number of convexities 12 such that the convexities 12 are close-packed on the surface (on the XY plane) of the base member 10 and increase the antireflection performance as the moth-eye structure. The plurality of convexities 12 of the micro concave-convex structure 11 is not, however, limited to the example of the hexagonal lattice shape. For example, the plurality of convexities 12 may be regularly arrayed in another manner such as a square lattice shape, a rectangular lattice shape, or a triangular lattice shape. Alternatively, the plurality of convexities 12 may be irregularly disposed on a surface of the base member 10. For example, while the plurality of convexities 12 is disposed on the basis of the disposition of any of the various lattice shapes, the plurality of convexities 12 may be irregularly disposed at positions randomly shifted from the base positions within a predetermined variation range.

### [4.1. Preferable Range of Pitch P of Convexities]

The pitch P of the convexities 12 may be, for example, the arithmetic mean value of the pitches (the dot pitches P_{D} or the track pitches P_{T}) of the plurality of pairs of adjacent convexities 12 and 12. For example, the plurality of pairs of two convexities 12 and 12 adjacent in the track direction (X direction) is picked up and the dot pitches P_{D} of the plurality of these pairs of convexities 12 and 12 are calculated or measured. The arithmetic mean value of the plurality of calculated or measured dot pitches P_{D} is then obtained and the arithmetic mean value may be used as the pitch P.

The magnitude of the pitch P is less than or equal to the wavelength λ of infrared rays used in the infrared sensor. It is preferable that the magnitude of the pitch P be less than the minimum value of the infrared wavelength band. For example, the pitch P may be less than 1000 nm, preferably greater than or equal to 100 nm and less than or equal to 900 nm. This allows the micro concave-convex structure 11 to favorably function as a moth-eye structure that reduces the reflection of infrared incident light in a wide wavelength band.

The pitch P less than 100 nm is not, however, preferable because it is difficult to form the micro concave-convex structure 11 by nano-imprinting or the like. The lower limit value of the pitch P is not thus limited in particular, but it is preferable that the lower limit value be greater than or equal to 100 nm from the perspective of forming the micro concave-convex structure 11 stably. In addition, the pitch P exceeding the wavelength λ of infrared rays used in the infrared sensor is not preferable because the infrared rays are diffracted and the antireflection performance is reduced as a moth-eye structure. Note that the magnitudes of the dot pitch P_{D} and the track pitch P_{T} may be the same or different as long as the magnitudes fall within the preferable range of the pitch P.

### [4.2. Preferable Shape of Convexity 12]

As illustrated in FIGS. 6 to 8, the three-dimensional shape of the convexity 12 of the micro concave-convex structure 11 may be, for example, any shape such as a cone shape (a circular-cone shape, an elliptical-cone shape, or a pyramid shape), a frustum shape (a circular-cone frustum shape, an elliptical-cone frustum shape, or a truncated pyramid shape), a bell shape, a dome shape, a protruding shape, or a needle shape as long as the three-dimensional shape is a shape projecting in the direction (Z direction) vertical to a surface of the base member 10. It is preferable that the planar shape of the convexity 12 be, for example, a circular shape (see FIG. 5) or an elliptical shape (see FIG. 4), but may be any shape such as a polygonal shape. Note that the planar shape of the convexity 12 is a planar shape indicating the outer shape of the convexity 12 obtained by projecting the convexity 12 upon a surface (XY plane) of the base member 10.

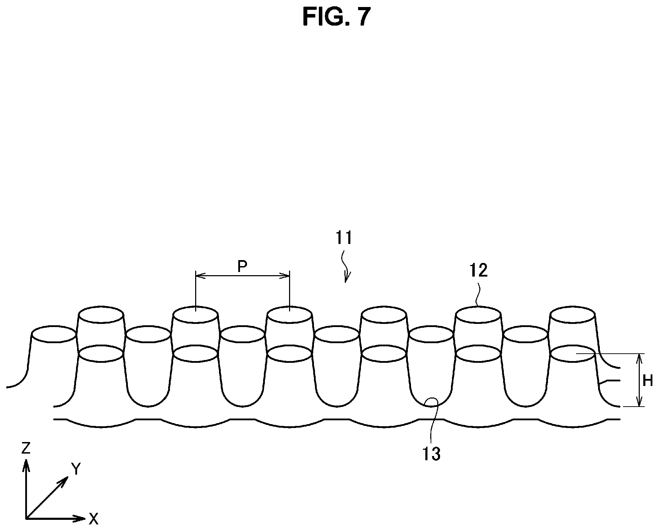

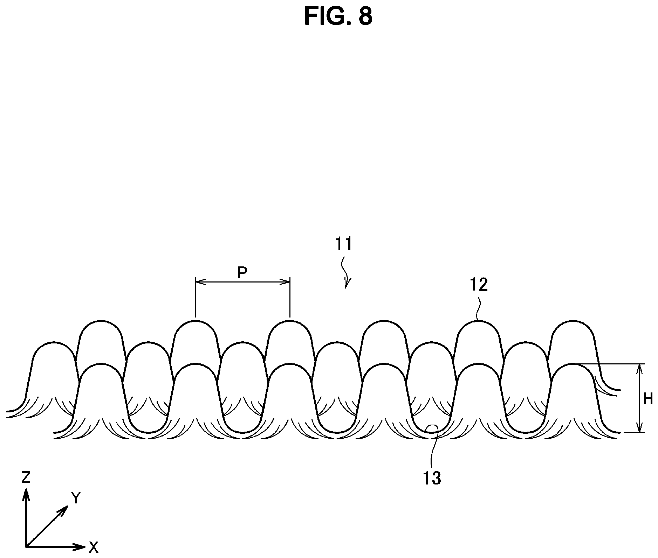

From the perspective of ease in molding the convexity 12, it is preferable that the three-dimensional shape of the convexity 12 be a three-dimensional shape the planar shape of which is substantially an elliptical shape (see FIG. 4). Specifically, it is preferable that the three-dimensional shape of the convexity 12 be substantially an elliptical-cone shape (see FIG. 6), an elliptical-cone frustum shape (see FIG. 7) the top of which is flat, a bell shape or a dome shape (see FIG. 8) the planar shape of which is an elliptical shape, or the like.

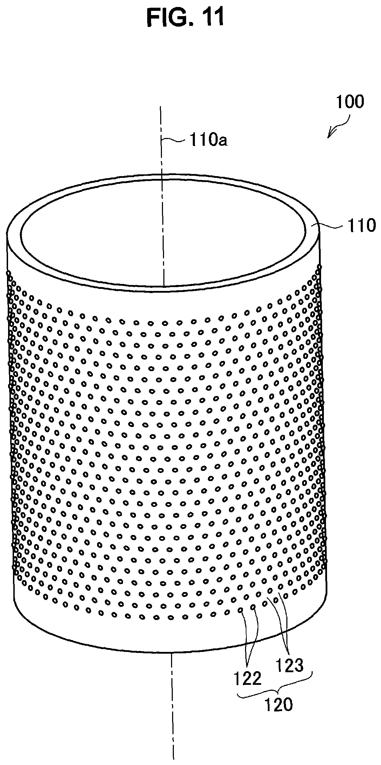

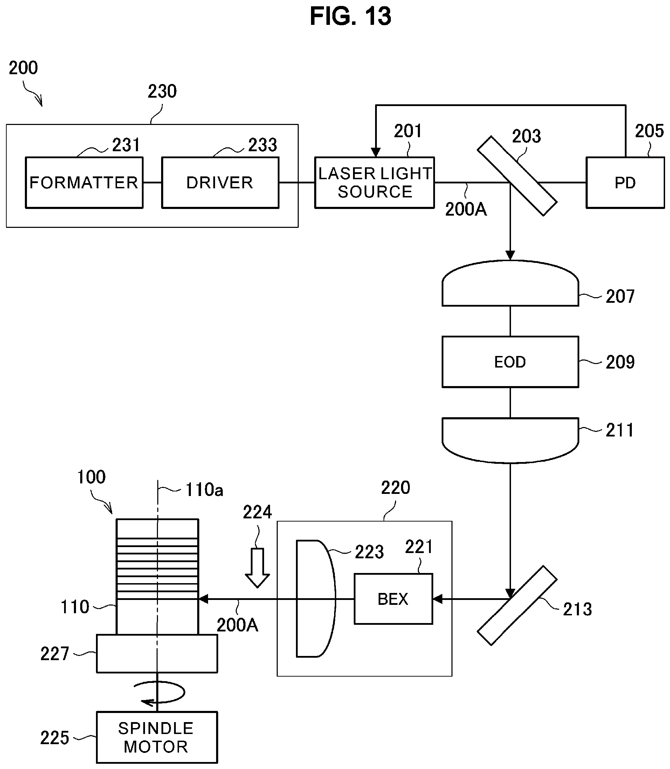

In this manner, it is preferable that the three-dimensional shape of the convexity 12 be a shape such as an elliptical cone obtained by elongating or contracting a cone shape in the track direction (X direction). In this manner, if the shape of the convexity 12 is a three-dimensional shape having an elliptical planar shape (see FIG. 4), it is easier to efficiently manufacture the micro concave-convex structure 11 including a large number of convexities 12. For example, according to a method (see FIG. 13) for manufacturing a master 100 using a laser exposure method described below, the planar shape of a concavity 122 (see FIG. 11) of a micro concave-convex structure 120 formed on the outer peripheral surface of the roll-shaped master 100 tends to be an elliptical shape and it is difficult to obtain a perfectly circular shape. The concavity 122 of the micro concave-convex structure 120 of this master 100 has a shape obtained by inverting the convexity 12 of the micro concave-convex structure 11 of the cover 7. It is thus preferable to accept that the shape of the convexity 12 of the micro concave-convex structure 11 molded using the roll-shaped master 100 is a three-dimensional shape having an elliptical planar shape. This makes it possible to manufacture the micro concave-convex structure 11 including the elliptical convexity 12 with ease and high accuracy using the method for manufacturing the master using the laser exposure method.

Additionally, in the present specification, being substantially an elliptical shape means that the shape is not limited to a geometrically strictly elliptical shape and includes, for example, a shape which can be generally considered an elliptical shape such as an elongate circular shape and an egg shape. Similarly, being substantially an elliptical-cone shape or an elliptical-cone frustum shape means that the shape is not limited to a geometrically strictly elliptical-cone shape or elliptical-cone frustum shape and includes a shape (e.g., such as a distorted shape obtained by elongating or contracting a cone shape or a frustum shape in the track direction (X direction)) which can be generally considered as elliptical-cone shape or elliptical-cone frustum shape.

### [4.3. Material of Micro Concave-convex Structure]

Although described in detail below, the micro concave-convex structure 11 is molded, for example, by roll-to-roll (roll-to-roll) imprinting that uses a roll master. The concave-convex shape formed on the outer peripheral surface of the roll master has a shape obtained by inverting the micro concave-convex structure 11. The concave-convex shape on the outer peripheral surface of this roll master is transferred to an uncured resin layer laminated on a surface of the base member 10 and the uncured resin layer is then cured to form the micro concave-convex structure 11. In this manner, the micro concave-convex structure 11 is transferred onto a surface of the base member 10 of the cover 7 using the roll master to make it possible to manufacture the cover 7 having an antireflection function with ease. To manufacture the cover 7 using such imprinting technology, the micro concave-convex structure 11 may be formed, for example, on a resin layer laminated on a surface of the base member 10 or may be formed on a resin layer that is included in the base member 10 itself. The resin layer on which this micro concave-convex structure 11 is formed includes, for example, a cured product of curable resin.

It is preferable that the cured product of curable resin have transparency. The curable resin includes a polymerizable compound and a curing initiator. The polymerizable compound is resin that is cured by the curing initiator. Examples of the polymerizable compound include a polymerizable epoxy compound, a polymerizable acrylic compound, and the like. The polymerizable epoxy compound is a monomer, an oligomer, or a prepolymer having one or two or more epoxy groups in the molecule. The polymerizable epoxy compound includes various bisphenol epoxy resins (such as bisphenols A and F), a novolac epoxy resin, various modified epoxy resins such as rubber or urethane, a naphthalene epoxy resin, a biphenyl epoxy resin, a phenol novolac epoxy resin, a stilbene epoxy resin, a triphenol methane epoxy resin, a dicyclopentadiene epoxy resin, a triphenyl methane epoxy resin, prepolymers thereof, and the like.

The polymerizable acrylic compound is a monomer, an oligomer, or a prepolymer having one or two or more acrylic groups in the molecule. Here, the monomer is further classified into a monofunctional monomer having one acrylic group in the molecule, a bifunctional monomer having two acrylic groups in the molecule, and a multifunctional monomer having three or more acrylic groups in the molecule.

Examples of the "monofunctional monomer" include carboxylic acids (such as acrylic acid), hydroxy monomers (2-hydroxyethyl acrylate, 2-hydroxypropyl acrylate, 4-hydroxybutyl acrylate), alkyl or alicyclic monomers (isobutyl acrylate, t-butyl acrylate, isooctyl acrylate, lauryl acrylate, stearyl acrylate, isobornyl acrylate, cyclohexyl acrylate), other functional monomers (2-methoxyethyl acrylate, methoxyethylene glycol acrylate, 2-ethoxyethyl acrylate, tetrahydrofurfuryl acrylate, benzyl acrylate, ethyl carbitol acrylate, phenoxyethyl acrylate, N,N-dimethylamino ethyl acrylate, N,N-dimethylamino propyl acrylamide, N,N-dimethyl acrylamide, acryloyl morpholine, N-isopropyl acrylamide, N,N-diethyl acrylamide, N-vinylpyrrolidone, 2-(perfluorooctyl)ethyl acrylate, 3-perfluorohexyl-2-hydroxypropyl acrylate, 3-perfluorooctyl-2-hydroxypropyl-acrylate, 2-(perfluorodecyl)ethyl-acrylate, 2-(perfluoro-3-methylbutyl)ethyl acrylate), 2,4,6-tribromophenol acrylate, 2,4,6-tribromophenol methacrylate, 2-(2,4,6-tribromophenoxy)ethyl acrylate), 2-ethylhexyl acrylate, and the like.

Examples of the "bifunctional monomer" include tri(propylene glycol) diacrylate, trimethylolpropane-diaryl ether, urethane acrylate, and the like.

Examples of the "multifunctional monomer" include trimethylolpropane triacrylate, dipentaerythritol penta- and hexaacrylate, ditrimethylolpropane tetraacylate, and the like.

Examples other than the polymerizable acrylic compounds listed above include acrylmorpholine, glycerol acrylate, polyether acrylates, N-vinylformamide, N-vinylcaprolactam, ethoxy diethylene glycol acrylate, methoxy triethylene glycol acrylate, polyethylene glycol acrylate, ethoxylated trimethylolpropane triacrylate, ethoxylated bisphenol A diacrylate, aliphatic urethane oligomers, polyester oligomers, and the like. From the perspective of the transparency of the cover 7, a polymerizable acrylic compound is preferable as the polymerizable compound.

The curing initiator is material that cures curable resin. Examples of the curing initiator include, for example, a thermal curing initiator, a light curing initiator, and the like. The curing initiator may be cured with a certain energy beam (e.g., electron beam) or the like other than heat and light. In a case where the curing initiator is a thermal curing initiator, the curable resin is a thermosetting resin. In a case where the curing initiator is a light curing initiator, the curable resin is a photocurable resin.

Here, from the perspective of the transparency of the cover 7, it is preferable that the curing initiator be an ultraviolet curing initiator. It is thus preferable that the curable resin be an ultraviolet curable acrylic resin. The ultraviolet curing initiator is a type of light curing initiator. Examples of the ultraviolet curing initiator include 2,2-dimethoxy-1,2-diphenylethane-1-one, 1-hydroxy-cyclohexyl phenyl ketone, 2-hydroxy-2-methyl-1-phenyl propane-1-one, and the like.

In addition, the resin that forms the micro concave-convex structure 11 may be resin having functionalities such as hydrophilicity, water repellency, and antifogging.

In addition, an additive depending on the application of the cover 7 may be added to the resin that forms the micro concave-convex structure 11. Examples of such an additive include an inorganic filler, an organic filler, a leveling agent, a surface conditioning agent, an antifoaming agent, and the like. Note that examples of the types of inorganic fillers include metal oxide microparticles such as SiO₂, TiO₂, ZrO₂, SnO₂, and Al₂O₃.

Note that the micro concave-convex structure 11 may be directly formed on the resin layer on the surface of the base member 10 by imprinting that uses a roll master as described above. This example is not, however, limitative. For example, a resin film (e.g., thermoplastic resin film) on which the micro concave-convex structure 11 is formed may be bonded to the surface of the base member 10.

### [5. Features of Height H and Pitch P of Convexities of Micro Concave-convex Structure]

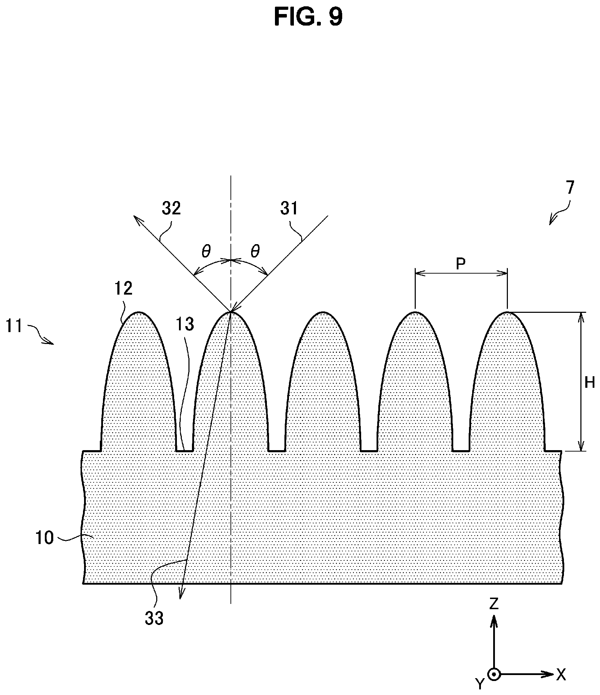

Next, features of height H and the pitch P of the convexities 12 of the micro concave-convex structure 11 according to the present embodiment will be described with reference to FIG. 9. FIG. 9 is a partially enlarged sectional view of the micro concave-convex structure 11 according to the present embodiment.

As illustrated in FIG. 9, the infrared sensor cover 7 according to the present embodiment includes the micro concave-convex structure 11 to reduce the reflection of incident light 31 (also referred to as "oblique-incidence light 31" below in some cases) incident upon a surface (XY plane) of the base member 10 from the inclination direction. The micro concave-convex structure 11 includes the plurality of convexities 12 regularly disposed on the surface of the base member 10 at the predetermined pitch P. The individual convexities 12 project to extend in the direction (Z direction: normal direction) vertical to the surface of the base member 10. The height H of the convexity 12 is the length from the base to the peak of the convexity 12 in the normal direction (Z direction). The pitch P of the convexities 12 is the distance between the peaks of the convexities 12 and 12 adjacent on the XY plane.

From the perspective of the uniform transmissivity and light distribution of the cover 7 for infrared rays, it is preferable that the heights H of the plurality of convexities 12 be the same and the pitches P of the convexities 12 be equal as in the example illustrated in FIG. 9. This example is not, however, limitative. The heights H of the plurality of convexities 12 may be inequal within a predetermined error range. The pitches P of the convexities 12 may also be inequal within a predetermined error range.

It is preferable that the pitch P of the convexities 12 be less than or equal to the wavelength λ of the infrared incident light 31 incident upon the cover 7 (P ≤ λ). This causes the micro concave-convex structure 11 to function as a moth-eye structure that reduces the reflection of infrared rays having the wavelength λ and it is thus possible to reduce the reflection of the infrared rays having the wavelength λ on the surface of the cover 7.

### [5.1. Ratio of Height H of Convexity to Wavelength λ (First Condition)]

Here, a condition for the height H of the convexity 12 will be described as a first condition for the micro concave-convex structure 11 according to the present embodiment.

It is preferable that the ratio (= H/λ) of the height H of the convexity 12 to the wavelength λ of the infrared incident light 31 be greater than or equal to 0.5. That is, it is preferable that the height H of the convexity 12 be 0.5 times the wavelength λ or more and the following Expression (1) be satisfied. $H / λ \geq 0.5$ (1)

The satisfaction of Expression (1) makes it possible to increase the antireflection performance for the oblique-incidence light 31. It is thus possible to increase the antireflection characteristics of the micro concave-convex structure 11 for the oblique-incidence light 31 within a wide range of the incidence angles θ (e.g., θ = -60° to +60°) including large-angle incidence (e.g., 45° or more). This reason will be described below.

In the present embodiment, the micro concave-convex structure 11 (moth-eye structure) in which the plurality of micro convexities 12 is disposed at the pitch P less than or equal to the wavelength λ of the infrared incident light 31 is formed on a surface of the base member 10 of the cover 7. This makes it possible to continuously change a refractive index n at the interface between air and the cover 7 and reduce the reflection of the incident light 31 on the surface of the cover 7. Here, to increase the antireflection effect of the micro concave-convex structure 11 for oblique-incidence light, it is preferable to make the change in the refractive index n as gentle as possible. To this end, it is preferable to make the height H of the convexity 12 of the micro concave-convex structure 11 greater than or equal to a predetermined height.

Accordingly, the inventors of the present invention have done a simulation by an RCWA (Rigorous Coupled-Wave Analysis) method and have actively studied the relationship between an antireflection effect for oblique-incidence light, particularly the oblique-incidence light 31 at a large angle, and the height H of the convexity 12. As a result, the inventors have learned that the height H of the convexity 12 which is 0.5 times the wavelength λ of obliquely incident infrared rays (i.e., Expression (1) above is satisfied) or more makes it possible to increase the antireflection effect for the oblique-incidence light 31. In particular, as the incidence angle θ of the oblique-incidence light 31 grows larger, the increase in the antireflection effect stands out more. Accordingly, the inventors of the present invention have found that the condition (first condition) that the ratio (H/λ) of the height H of the convexity 12 to the wavelength λ of the oblique-incidence light 31 is greater than or equal to 0.5 is of importance on the basis of this knowledge and have conceived of the micro concave-convex structure 11 that satisfies the first condition.

Even in a case where the infrared oblique-incidence light 31 is incident upon a surface of the cover 7 at a large angle as illustrated in FIG. 9, the satisfaction of the first condition (H/λ ≥ 0.5) by the micro concave-convex structure 11 makes it possible to reduce reflected light 32 reflected on the surface of the cover 7 and increase transmitted light 33 passing through the cover 7. This makes it possible to reduce the reflectance of the surface of the cover 7 for the oblique-incidence light 31, for example, to 3% or less, preferably 2.5% or less, and increase the transmittance for the oblique-incidence light 31 passing through the cover 7, for example, to 97% or more, preferably 97.5% or more. The cover 7 including the micro concave-convex structure 11 according to the present embodiment thus makes it possible to considerably increase the antireflection performance for infrared rays (particularly near-infrared rays) obliquely incident within a wide range of the incidence angles θ (e.g., -60° to +60°) including large-angle incidence in comparison with the conventional technology and reduce the reflectance for the oblique-incidence light 31 at a large angle to 3% or less. It is thus possible to considerably increase the detection accuracy of the infrared sensor covered with the cover 7 according to the present embodiment.

### [5.2. Ratio (Second Condition) of Pitch P to Wavelength λ]

Next, a condition for the pitch P of the convexities 12 will be described as a second condition for the micro concave-convex structure 11 according to the present embodiment.

It is preferable that the ratio (= P/λ) of the pitch P of the convexities 12 to the wavelength λ of the infrared incident light 31 be less than or equal to 0.5. That is, it is preferable that the pitch P of the convexities 12 be 0.5 times the wavelength λ or less and the following Expression (2) be satisfied. $P / λ \leq 0.5$ (2)

The satisfaction of Expression (2) makes it possible to increase the amount of transmitted light of the infrared incident light 31 passing through the cover 7. It is thus possible to increase the amount of light received by the infrared sensor covered with the cover 7 and the amount of light emitted from the infrared sensor, allowing the infrared sensor to have higher detection accuracy. This reason will be described below.

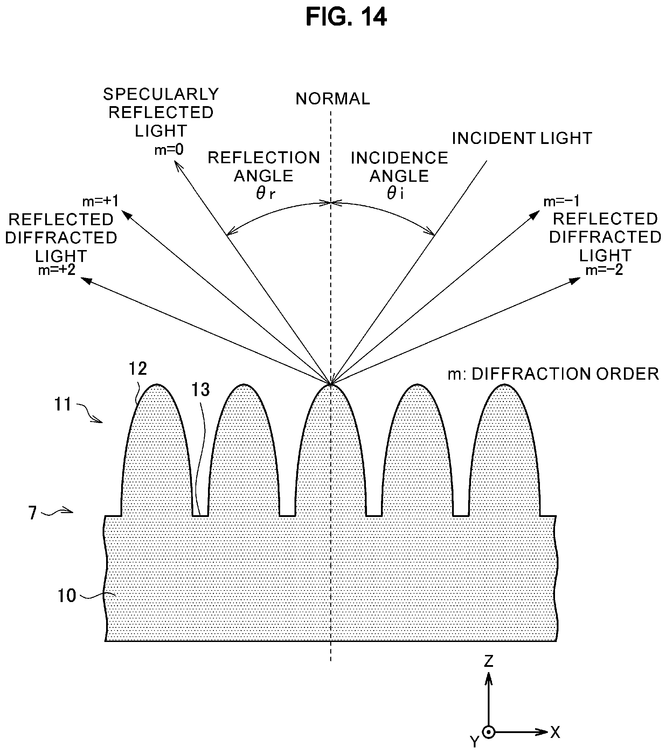

In a case where there is provided a periodical micro concave-convex structure on a surface of an optical element, higher-order diffracted light is typically generated when light passes through the micro concave-convex structure. The straight-propagating component of the transmitted light is considerably reduced (see FIG. 14). However, in a case where the pitch P of the convexities of the micro concave-convex structure is shorter than the wavelength λ of the transmitted light, the diffracted light is reduced.

In this regard, if the pitch P is too wide in comparison with the wavelength λ of the oblique-incidence light 31, the oblique-incidence light 31 is bent due to the diffraction of the oblique-incidence light 31 on a surface of the cover 7. This reduces the amount of light received and the amount of light emitted by the infrared sensor. The detection accuracy of the infrared sensor is thus reduced.

In contrast, in the micro concave-convex structure 11 according to the present embodiment, the ratio of the pitch P to the wavelength λ is set to be less than or equal to 0.5 (second condition) and the pitch P is set to have the appropriate magnitude corresponding to the wavelength λ. This makes it possible to reduce the generation of higher-order diffracted light on a surface of the cover 7 and it is thus possible to increase the straight-propagating properties of the oblique-incidence light 31 and increase the amount of transmitted light 33 passing through the cover 7. It is thus possible to increase the amount of transmitted light 33 traveling to the infrared sensor through the cover 7 and the amount of irradiation light emitted from the infrared sensor through the cover 7. This makes it possible to increase the amount of light received and the amount of light emitted by the infrared sensor and it is thus possible to further increase the detection accuracy of the infrared sensor.

Furthermore, the satisfaction of both the first condition (H/λ ≥ 0.5) and the second condition (P/λ ≤ 0.5) makes it possible to implement the micro concave-convex structure 11 having a superior antireflection effect for the oblique-incidence light 31 at a large angle and a superior effect of reducing diffracted light.

### [5.3. Aspect Ratio (H/P) of Convexity (Third Condition)]

Next, a condition for the aspect ratio of the convexity 12 will be described as a third condition for the micro concave-convex structure 11 according to the present embodiment.

The aspect ratio is the ratio of the height H to the pitch P of the convexities 12 (= H/P). It is preferable that this aspect ratio (H/P) be less than or equal to 3. That is, it is preferable that the height H of the convexity 12 be three times the pitch P or less and the following Expression (3) be satisfied. $H / P \leq 3$ (3)

The satisfaction of Expression (3) makes it possible to increase the releasability for releasing, when the micro concave-convex structure 11 is molded on a surface of the cover 7 by imprinting that uses a master, the master from the cover 7 having the micro concave-convex structure 11 transferred thereto. It is thus possible to mold the micro concave-convex structure 11 by imprinting that uses a master with ease and high accuracy.

That is, in a case where the pitch P of the convexities 12 included in the micro concave-convex structure 11 is too narrow or the height H of the convexity 12 is too great, the aspect ratio (H/P) grows too high. This reduces the releasability at the time of the imprinting and makes it more difficult to manufacture the micro concave-convex structure 11.

In contrast, according to the micro concave-convex structure 11 according to the present embodiment, the aspect ratio (H/P) is set to be less than or equal to 3 (third condition) and the height H is set to have the appropriate magnitude corresponding to the pitch P. This makes it possible to increase the releasability at the time of the imprinting and it is thus possible to mold the micro concave-convex structure 11 having a desired shape with ease and high accuracy without causing any defect in the micro concave-convex structure 11.

### [5.4. Result of Simulation]

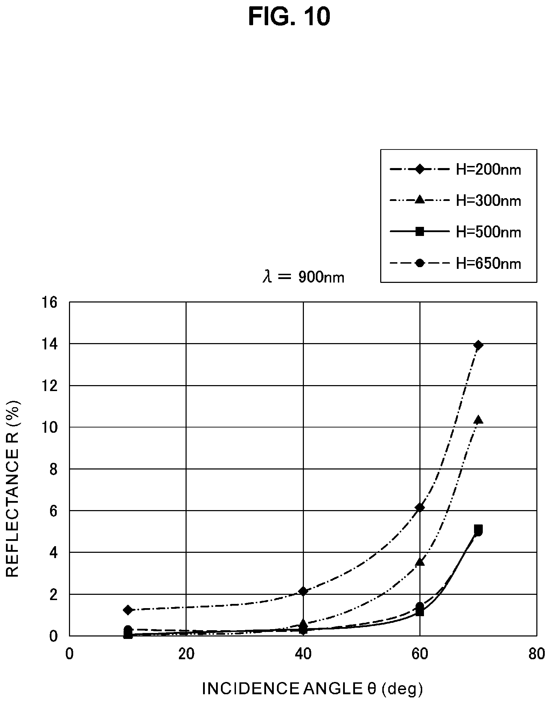

Next, to verify the antireflection effect under the first condition (H/λ ≥ 0.5) for the height H of the convexity 12, a result obtained by simulating the relationship between the height H of the convexity 12 of the micro concave-convex structure 11 and reflectance R [%] of a surface of the micro concave-convex structure 11 for incident light for each of the incidence angles θ [°] will be described with reference to FIG. 10. FIG. 10 is a graph illustrating a result of the simulation.

Conditions for this simulation are as follows.
wavelength λ of incident light: 900 nm
incidence angle θ of incident light: 10°, 40°, 60°, and 70°
height H of convexity 12: 200 nm, 300 nm, 500 nm, and 650 nm
longitudinal cross-sectional shape of convexity 12: parabolic approximation
planar shape of convexity 12: circular shape
planar disposition of convexities 12: hexagonal lattice shape (see FIG. 5)
pitch P of convexities 12: 300 nm
refractive index of material of convexity 12: 1.5
refractive index of air: 1.0

Table 1 shows the relationship between the height H [nm] of the convexity 12, the incidence angle θ [°], and the reflectance R [%] for incident light offered by this simulation. In addition, this relationship is also illustrated in the graph of FIG. 10.

### [Table 1]

**Table 1**

| No. | 1 | 2 | 3 | 4 |
|---|---|---|---|---|
| height H of convexity | 200 nm | 300 nm | 500 nm | 650 nm |
| wavelength λ | 900 nm | 900 nm | 900 nm | 900 nm |
| H/λ | 0.22 | 0.33 | 0.56 | 0.72 |

| incidence angle θ | reflectance R [%] | | | |
|---|---|---|---|---|
| 10° | 1.2 | 0.07 | 0.04 | 0.3 |
| 40° | 2.1 | 0.52 | 0.26 | 0.28 |
| 60° | 6.14 | 3.52 | 1.14 | 1.41 |
| 70° | 13.94 | 10.33 | 5.14 | 4.96 |

As shown in Table 1 and FIG. 10, in a case where the convexity 12 has any of the heights H, the reflectance R grows higher as the incidence angle θ of oblique-incidence light grows larger. It is, however, shown that the absolute value and the rate of increase of the reflectance R can be kept at smaller values in the case of H = 500 m and 650 nm than in the case of H = 200 nm and 300 nm. For example, in the case of large-angle incidence at θ = 60°, the reflectances R in the case of H = 200 m and 300 nm are respectively 6.14% and 3.52% and considerably exceed reference reflectance (e.g., 3%, preferably 2.5%). The antireflection effect by the micro concave-convex structure 11 is thus reduced in the case of the less height H. In contrast, the reflectances R in the case of H = 500 m and 650 nm are respectively 1.14% and 1.41% and are sufficiently lower than the reference reflectance (e.g., 3%, preferably 2.5%). It can be thus said that the antireflection effect is superior for oblique-incidence light at a large angle of about 60° in the case of the great height H. Note that the reference reflectance is a reference upper limit value (e.g., 3%, preferably 2.5%) of reflectance requested from an infrared sensor cover used for an in-vehicle LiDAR or the like.

Thus, according to the result of the simulation, if the height H of the convexity 12 is greater than or equal to a certain height (e.g., 500 nm) in comparison with the wavelength λ of oblique-incidence light and H/λ is greater than or equal to 0.5, it is possible to keep the reflectance R for oblique-incidence light within a wide range (10° to 60°) including large-angle incidence at about 60° at 3% or less, preferably 1.5% or less. This exhibits a significantly superior antireflection effect for the oblique-incidence light.

### [6. Configuration of Master]

Next, the master 100 used to mold the micro concave-convex structure 11 of the infrared sensor cover 7 according to the present embodiment will be described with reference to FIG. 11. FIG. 11 is a schematic perspective view of the master 100 according to the present embodiment.

The master 100 is a mold for transferring the micro concave-convex structure 120 to a surface of a transfer object (e.g., the infrared sensor cover 7 according to the present embodiment) by roll-to-roll imprinting. From the perspective of efficient production of the transfer object, it is preferable that the master 100 be a roll-shaped master having a cylindrical shape or a columnar shape, but the master 100 may be a master shaped like a flat plate. If the master 100 is a roll-shaped master, it is possible to seamlessly transfer the micro concave-convex structure 120 of the master 100 to the base member or the like of the transfer object by a roll-to-roll method. This makes it possible to manufacture the transfer object having the micro concave-convex structure 120 of the master 100 transferred thereto at high production efficiency.

As illustrated in FIG. 11, the master 100 includes a roll-shaped base member 110 and the micro concave-convex structure 120 formed on the outer peripheral surface of the base member 110.

The base member 110 is, for example, a roll-shaped member that serves as the base member of the roll master. The shape of the base member 110 may be a hollow cylindrical shape as illustrated in FIG. 11 or may be a solid columnar shape having no cavity therein. In addition, the material of the base member 110 is not limited in particular. Quartz glass (SiO₂) such as fused quartz glass or synthetic quartz glass or metal such as stainless steel is usable. The size of the base member 110 is not limited in particular. For example, the length of the base member 110 in the direction (referred to as an axial direction below in some cases) of a central axis 110a may be greater than or equal to 100 mm. In addition, the outside diameter of the base member 110 may be greater than or equal to 50 mm and less than or equal to 300 mm. In addition, the thickness of the base member 110 having a cylindrical shape in the radial direction may be greater than or equal to 2 mm and less than or equal to 50 mm.

The micro concave-convex structure 120 is a micro concave-convex pattern formed on the outer peripheral surface of the master 100. The micro concave-convex structure 120 includes the plurality of micro concavities 122 arrayed at the predetermined pitch P and a plurality of micro convexities 123 provided between the two adjacent concavities 122. The micro concave-convex structure 120 of the master 100 has a shape obtained by inverting a micro concave-convex structure (e.g., the micro concave-convex structure 11 of the cover 7) of a transfer object. For example, the shape of the concavity 122 of the micro concave-convex structure 120 of the master 100 is a shape obtained by inverting the convexity 12 (see FIGS. 2 to 9) of the micro concave-convex structure 11 of the cover 7. Similarly, the shape of the convexity 123 of the micro concave-convex structure 120 of the master 100 is a shape obtained by inverting the concavity 13 (see FIGS. 2 to 9) of the micro concave-convex structure 11 of the cover 7 described above. In addition, the pitch (the dot pitch in the circumferential direction) of the concavities 122 of the micro concave-convex structure 120 of the master 100 is the same as the pitch P of the convexities 12 of the micro concave-convex structure 11 of the cover 7.

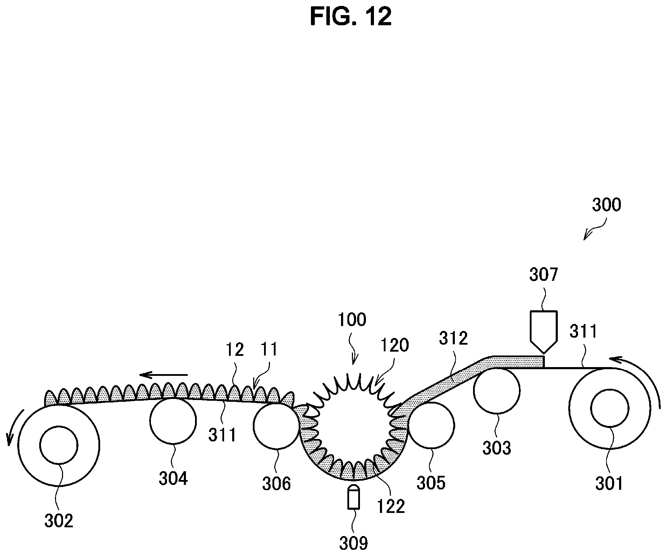

The master 100 having this configuration is provided to a roll-to-roll imprinting transfer device. For example, the master 100 is provided to a transfer device 300 illustrated in FIG. 12. The master 100 makes it possible to manufacture a transfer object (e.g., the infrared sensor cover 7 according to the present embodiment) to which the micro concave-convex structure 120 formed on the outer peripheral surface of the master 100 has been transferred. For example, it is possible to efficiently mold the micro concave-convex structure 11 on a surface of the cover 7 with high accuracy by continuously transferring the micro concave-convex structure 120 on the outer peripheral surface of the master 100 to a resin layer on the surface of the cover 7.

### [7. Method for Manufacturing Transfer Object]

Next, a method for efficiently manufacturing a transfer object such as the infrared sensor cover 7 according to the present embodiment using the transfer device 300 including the master 100 will be described with reference to FIG. 12. FIG. 12 is a schematic diagram illustrating the configuration of the transfer device 300 that manufactures a transfer object using the master 100 according to the present embodiment.

As illustrated in FIG. 12, the transfer device 300 is a roll-to-roll imprinting transfer device. The transfer device 300 transfers the micro concave-convex structure 120 of the master 100 to a resin layer of a transfer target object by a roll-to-roll method. This makes it possible to continuously manufacture the transfer objects to each of which the micro concave-convex structure 120 formed on the outer peripheral surface of the master 100 has been transferred.

As illustrated in FIG. 12, the transfer device 300 includes the master 100, a base member supply roll 301, a take-up roll 302, guide rolls 303 and 304, a nip roll 305, a release roll 306, a coating device 307, and a light source 309.

The base member supply roll 301 is, for example, a roll obtained by winding a film-shaped base member 311 into a roll shape. The take-up roll 302 is a roll for taking up a film-shaped base member 331 including a resin layer 312 having the micro concave-convex structure 120 transferred thereto. In addition, the guide rolls 303 and 304 are rolls for transporting the film-shaped base member 311 before and after the transfer. The nip roll 305 is a roll for pressing the film-shaped base member 311 having the resin layer 312 laminated thereon against the master 100. The release roll 306 is a roll for releasing, from the master 100, the film-shaped base member 311 in which the micro concave-convex structure 120 has been transferred to the resin layer 312.

Note that the film-shaped base member 311 may be the same base member as the base member 10 (see FIG. 2 and the like) of the infrared sensor cover 7 according to the present embodiment described above or may be another base member different from the base member 10. In the latter case, the cover 7 may be manufactured by bonding, to a surface of the base member 10 (see FIGS. 2 and 3 and the like) of the cover 7, the base member 311 including the resin layer 312 having the micro concave-convex structure 120 transferred thereto by the transfer device 300 in FIG. 12. For example, in the present embodiment, the cover 7 including the micro concave-convex structure 11 is configured by bonding, to a surface of the base member 10 (see FIGS. 2 and 3 and the like) of the cover 7, the film-shaped base member 311 (see FIG. 12) including the resin layer 312 having the micro concave-convex structure 120 transferred thereto.

The coating device 307 includes a coating means such as a coater and coats the film-shaped base member 311 with a photocurable resin composition to form the resin layer 312. The coating device 307 may be, for example, a gravure coater, a wire bar coater, a die coater, or the like. In addition, the light source 309 is a light source that emits light having a wavelength which allows the photocurable resin composition to be cured. The light source 309 may be, for example, an ultraviolet lamp or the like.

Note that the photocurable resin composition is a resin which is cured when irradiated with light having a predetermined wavelength. Specifically, the light curable resin composition may be, for example, an ultraviolet curable resin such as acrylic resin acrylate or epoxy acrylate. In addition, the photocurable resin composition composition may include an initiator, a filler, a functional additive, a solvent, an inorganic material, a colorant, an antistatic agent, a sensitizing dye, or the like as necessary.

Note that the resin layer 312 may be formed using a thermosetting resin composition. In this case, the transfer device 300 is provided with a heater instead of the light source 309 and the heater heats the resin layer 312 to cure the resin layer 312 and transfer the micro concave-convex structure 120. The thermosetting resin composition may be, for example, a phenolic resin, an epoxy resin, a melamine resin, a urea resin, or the like.

Next, a method for manufacturing a transfer object using the transfer device 300 will be described.

First, the film-shaped base member 311 is continuously fed out from the base member supply roll 301 and conveyed by the guide roll 303. Subsequently, a surface of the fed base member 311 is coated with a photocurable resin composition by the coating device 307 and the uncured resin layer 312 is laminated on the surface of the base member 311.

Furthermore, the uncured resin layer 312 laminated on the surface of the base member 311 is pressed against the outer peripheral surface of the master 100 by the nip roll 305. This transfers the micro concave-convex structure 120 formed on the outer peripheral surface of the master 100 to the uncured resin layer 312. Thereafter, the resin layer 312 having the micro concave-convex structure 120 transferred thereto is irradiated with, for example, light such as ultraviolet rays from the light source 309. This cures the uncured resin layer 312 and stabilizes the shape of the concave-convex pattern transferred to the cured resin layer 312.

Subsequently, the base member 311 having the cured resin layer 312 laminated thereon is released from the outer peripheral surface of the master 100 by the release roll 306. This forms, on the resin layer 312, the micro concave-convex structure 11 having a shape obtained by inverting the micro concave-convex structure 120 of the master 100. Thereafter, the base member 311 released from the master 100 is conveyed via the guide roll 304 and taken up by the take-up roll 302.

In this manner, it is possible to continuously manufacture transfer objects (e.g., the infrared sensor cover 7 according to the present embodiment) to each of which the micro concave-convex structure 120 formed on the master 100 has been transferred using the roll-to-roll transfer device 300. This makes it possible to manufacture transfer objects each having the micro concave-convex structure 120 transferred thereto with high accuracy efficiently in large quantities at low cost.

### [8. Method for Manufacturing Master]

### [8.1. Overview of Method for Manufacturing Master]

Next, a method (steps S10 to S50) for manufacturing the master 100 using a manufacturing apparatus for the master 100 according to the present embodiment will be described. The manufacturing apparatus for the master 100 according to the present embodiment includes, for example, a deposition device, an exposure control device, an exposure device, a development device, an etching device, an exposure control device, other various control devices, and the like.

### (S10: Resist Deposition Step)

According to the method for manufacturing the master 100 according to the present embodiment, first, a resist layer is formed on the outer peripheral surface of the base member 110 of the master 100 by the deposition device.

In more detail, it is preferable to use, for example, a base member including quartz glass or the like as the base member 110 of the master 100. The base member 110 is a roll-shaped base member having a cylindrical shape or a columnar shape. A resist layer is deposited on the outer peripheral surface of this base member 110 using resist material.

The resist layer is formed using inorganic material or organic material that allows latent images to be formed using laser light. It is possible to use a metal compound including a transition metal as the inorganic material. Preferably, metal oxide including one or two or more transition metals such as tungsten (W) or molybdenum (Mo) is usable. It is possible to deposit such inorganic material as a resist layer using, for example, a sputtering method or the like. Meanwhile, for example, a novolac resist, a chemically amplified resist, or the like is usable as the organic material. It is possible to deposit such organic material as a resist layer using, for example, a spin coating method or the like.

### (S20: Exposure Control Signal Generation Step)

Subsequently, an exposure control signal corresponding to the concave-convex pattern (exposure pattern) of the micro concave-convex structure 120 of the master 100 is generated by the exposure control device.

### (S30: Exposure Step)

Furthermore, the resist layer is irradiated with laser light by the exposure device on the basis of the exposure control signal generated in S20 above. The resist layer is thus exposed in a predetermined exposure pattern to form latent images corresponding to the micro concave-convex structure 120.

In more detail, the resist layer is irradiated with laser light by the exposure device to denature the section of the resist layer irradiated with the laser light. The resist layer is thus exposed and a plurality of latent images is formed on the resist layer. At the time of this exposure, the resist layer may be irradiated with laser light continuously or intermittently as exposure light.

### (S40: Development Step)

Subsequently, the resist layer having the latent images formed thereon is developed by the development device. This forms the resist pattern corresponding to the micro concave-convex structure 120 on the resist layer.

In more detail, the development device drops a developing solution onto the resist layer having the latent images formed thereon in S30 above to develop the resist layer. This forms the resist pattern having a three-dimensional concave-convex structure on the resist layer. This resist pattern includes a plurality of concavities each having a three-dimensional shape. The three-dimensional shapes of the plurality of concavities correspond to the respective three-dimensional shapes of the concavities 122 of the micro concave-convex structure 120.

Additionally, in a case where the resist layer is a positive-type resist, the exposed portion exposed to laser light has a higher rate of dissolution in the developing solution than that of an unexposed portion and is therefore removed by development treatment. This forms, on the resist layer, a resist pattern obtained by removing the portions of the latent images on the resist layer. In contrast, in a case where the resist layer is a negative-type resist, the exposed portion exposed to laser light has a lower rate of dissolution in the developing solution than that of an unexposed portion and the unexposed portion is therefore removed by development treatment. This forms, on the resist layer, a resist pattern having the portions of the latent images left thereon.

### (S50: Etching Step)

Thereafter, the outer peripheral surface of the base member 110 of the master 100 is etched by the etching device using, as a mask, the resist layer having the resist pattern formed thereon. This forms the concave-convex pattern corresponding to the micro concave-convex structure 120 on the outer peripheral surface of the base member 110.

In more detail, the outer peripheral surface of the base member 110 is etched using, as a mask, the resist layer having the resist pattern corresponding to the micro concave-convex structure 120 formed thereon in S40 above. This forms the micro concave-convex structure 120 (concave-convex pattern) including the plurality of concavities 122 on the outer peripheral surface of the base member 110. The concave-convex shape of the micro concave-convex structure 120 of the master 100 corresponds to the concave-convex shape of the resist pattern and is equivalent to a shape obtained by inverting the three-dimensional shape of the micro concave-convex structure 11 of the transfer object.

Note that both dry etching and wet etching are usable to etch the base member 110. For example, in a case where the material of the base member 110 is quartz glass (SiO₂), it is possible to etch the base member 110 using dry etching that uses fluorocarbon gas (e.g., CHF₃) or wet etching that uses hydrofluoric acid or the like.

### [8.2. Exposure Device and Exposure Method]

Next, an exposure device 200 and an exposure method used in the method for manufacturing the master 100 according to the present embodiment will be described in more detail with reference to FIG. 13. FIG. 13 is an explanatory diagram illustrating the schematic configuration of the exposure device 200 according to the present embodiment.

As illustrated in FIG. 13, the exposure device 200 includes a laser light source 201, a first mirror 203, a photodiode 205, a deflection optical system, a control mechanism 230, a second mirror 213, a moving optical table 220, a spindle motor 225, and a turntable 227. In addition, the base member 110 is placed on the turntable 227 and configured to be rotatable about the central axis 110a.

The laser light source 201 is a light source that emits laser light 200A. The laser light source 201 is, for example, a solid-state laser, a semiconductor laser, or the like. The wavelength of the laser light 200A emitted by the laser light source 201 is not limited in particular. The laser light 200A may have, for example, a wavelength in a blue light band of 400 nm to 500 nm. In addition, it is favorable that the spot diameter (the diameter of a spot for irradiation on the resist layer) of the laser light 200A be less than the diameter of the opening surface of the concavity 122 of the micro concave-convex structure 120. For example, a spot diameter of about 200 nm suffices. The laser light 200A emitted from the laser light source 201 is controlled by the control mechanism 230.

The laser light 200A emitted from the laser light source 201 propagates straight as a parallel beam as emitted and is reflected by the first mirror 203 to be guided to the deflection optical system.

The first mirror 203 includes a polarizing beam splitter and has a function of reflecting one of the polarization components and transmitting the other polarization component. The polarization component passing through the first mirror 203 is received by the photodiode 205 and subjected to photoelectric conversion. In addition, a light reception signal resulting from the photoelectric conversion by the photodiode 205 is input to the laser light source 201 and the laser light source 201 modulates the phase of the laser light 200A on the basis of the input light reception signal.

In addition, the deflection optical system includes a condenser lens 207, an electro optic deflector (Electro Optic Deflector: EOD) 209, and a collimator lens 211.

In the deflection optical system, the laser light 200A is condensed by the condenser lens 207 onto the electro optic deflector 209. The electro optic deflector 209 is an element capable of controlling an irradiated position with the laser light 200A. The exposure device 200 is also capable of changing the irradiated position with the laser light 200A guided onto the moving optical table 220 by the electro optic deflector 209 (so-called Wobble mechanism). After the irradiated position is adjusted by the electro optic deflector 209, the laser light 200A is collimated again as a parallel beam by the collimator lens 211. The laser light 200A emitted from the deflection optical system is reflected by the second mirror 213 to be guided onto the moving optical table 220 horizontally and in parallel.

The moving optical table 220 includes a beam expander 221 and an objective lens 223. After the laser light 200A guided to the moving optical table 220 is shaped into a desired beam shape by the beam expander 221, the resist layer formed on the base member 110 of the master 100 via the objective lens 223 is irradiated with the laser light 200A.

In addition, the moving optical table 220 moves by one feed pitch (track pitch) in the direction (feed pitch direction) of an arrow 224 along the axial direction of the base member 110 whenever the base member 110 rotates once. The base member 110 is installed on the turntable 227. The spindle motor 225 rotates the base member 110 about the central axis 110a of the master 100 having a cylindrical shape by rotating the turntable 227. The moving optical table 220 is moved in an R direction in this manner while the base member 110 is rotated. This irradiates the resist layer on the outer peripheral surface of the base member 110 with the laser light 200A along a spiral trajectory. As a result, latent images are formed on the resist layer along the spiral irradiation trajectory of the laser light 200A.

In addition, the control mechanism 230 includes a formatter 231 and a driver 233 and controls irradiation with the laser light 200A.

The driver 233 controls the emission of the laser light source 201 on the basis of an exposure signal generated by the formatter 231. Specifically, the driver 233 may control the laser light source 201 to increase the output intensity of the laser light 200A as the magnitude of the waveform amplitude of the exposure signal grows greater. In addition, the driver 233 may control the irradiated position with the laser light 200A by controlling the emission timing of the laser light 200A on the basis of the waveform shape of the exposure signal. As the output intensity of the laser light 200A grows higher, it is possible to form larger and deeper latent images on the resist layer. It is thus possible to eventually form a larger and deeper opening for the concavity 122 in the base member 110.

Under such exposure control by the control mechanism 230, the resist layer on the outer peripheral surface of the base member 110 of the master 100 is exposed and latent images having any pattern are formed on the resist layer. The resist layer is then developed and the outer peripheral surface of the base member 110 is etched using the developed resist layer as a mask. This makes it possible to form the micro concave-convex structure 120 having a concave-convex pattern corresponding to the drawing pattern of the input image on the outer peripheral surface of the base member 110 of the master 100. Thus, if a concave-convex pattern in which a shape obtained by inverting the micro concave-convex structure 11 of the infrared sensor cover 7 that is a transfer object has been drawn is prepared as a drawing pattern, it is possible to favorably form the micro concave-convex structure 120 having the shape obtained by inverting the micro concave-convex structure 11 of the cover 7 on the outer peripheral surface of the master 100.

### [9. Conclusion]

The infrared sensor cover 7 and the optical distance measurement apparatus 1 including the infrared sensor covered with the infrared sensor cover 7 according to the present embodiment have been described in detail so far.

According to the present embodiment, the infrared sensor cover 7 that covers an infrared sensor which measures the distance to a measurement target using infrared rays is provided. The cover 7 according to the present embodiment is disposed on the infrared sensor to allow infrared rays to be incident upon the cover 7 from a direction inclined with respect to a surface of the cover 7. The cover 7 includes the base member 10 and the micro concave-convex structure 11 provided on at least one surface of the base member 10. The micro concave-convex structure 11 includes the plurality of convexities 12 disposed at the pitch P less than or equal to the wavelength λ of infrared rays used in the infrared sensor. In the micro concave-convex structure 11, the ratio (H/λ) of the height H of the convexity 12 to the wavelength λ of infrared rays is greater than or equal to 0.5 (first condition: H/λ ≥ 0.5).

In this manner, a surface of the cover 7 according to the present embodiment is provided with the micro concave-convex structure 11 as an antireflection layer. The height H of each of the plurality of convexities 12 of this micro concave-convex structure 11 is height that is 0.5 times the wavelength λ of infrared rays or more (H/λ ≥ 0.5). For example, the height is adjusted to height at which superior antireflection performance is exhibited for infrared rays obliquely incident at a large angle of about 60°. This makes it possible to significantly increase the antireflection performance of the cover 7 for infrared rays (particularly near-infrared rays) obliquely incident within a wide range of incidence angles (e.g., θ = -60° or more and +60° or less) including normal incidence (θ = 0°) and large-angle incidence. It is thus possible to significantly reduce the reflectance of a surface of the cover 7 for infrared oblique-incidence light, for example, to 3% or less and significantly increase the transmittance for infrared rays passing through the cover 7, for example, to 97% or more. This allows infrared irradiation light radiated from the infrared sensor at a large angle through the cover 7 and infrared reflected light incident upon the infrared sensor at a large angle through the cover 7 to pass through the cover 7 at sufficient transmittance. It is thus possible to considerably increase the detection accuracy of the infrared sensor that radiates and receives infrared oblique-incidence light.

In addition, it is preferable that the ratio (P/λ) of the pitch P of the convexities 12 to the wavelength λ of infrared rays be less than or equal to 0.5 (second condition: P/λ ≤ 0.5).

This makes it possible to adjust the pitch P of the convexities 12 to appropriate magnitude corresponding to the wavelength λ of obliquely incident infrared rays. It is thus possible to reduce the generation of higher-order diffracted light on a surface of the cover 7 and thus increase the straight-propagating properties of infrared oblique-incidence light incident upon the cover 7. It is therefore possible to increase the amount of transmitted light traveling to the infrared sensor through the cover 7 and the amount of irradiation light emitted from the infrared sensor through the cover 7. This makes it possible to increase the amount of light received and the amount of light emitted by the infrared sensor and it is thus possible to further increase the detection accuracy of the infrared sensor.

In addition, it is preferable that the ratio (H/P) of the height H to the pitch P of the convexities 12 be less than or equal to 3 (third condition: H/P ≤ 3). That is, it is preferable that the aspect ratio of the convexity 12 be less than or equal to 3.

This makes it possible to adjust the ratio (aspect ratio) between the pitch P of the convexities 12 of the micro concave-convex structure 11 and the height H to magnitude appropriate for imprinting that uses the roll-shaped master 100. It is thus possible to favorably release the micro concave-convex structure 11 of the cover 7 from the micro concave-convex structure 120 on the outer peripheral surface of the master 100 at the time of the imprinting and increase the releasability. This makes it possible to mold the micro concave-convex structure 11 having a desired shape with ease and high accuracy without causing any defect in the micro concave-convex structure 11.

In addition, it is preferable that infrared rays used in the infrared sensor be near-infrared rays the wavelength λ of which is greater than or equal to 800 nm and less than or equal to 2500 nm.

This makes it possible to favorably apply the cover 7 according to the present embodiment to the optical distance measurement apparatus 1 such as a LiDAR including a near-infrared sensor that uses near-infrared rays.

In addition, it is preferable that the shape of the convexity 12 of the micro concave-convex structure 11 be substantially an elliptical-cone shape, an elliptical-cone frustum shape, or a bell shape or a dome shape the planar shape of which is an elliptical shape.

In this manner, if the shape of the convexity 12 is a three-dimensional shape (see FIGS. 6 to 8) having an elliptical planar shape (see FIG. 4), it is easier to efficiently manufacture the micro concave-convex structure 11 including a large number of convexities 12. For example, according to the method (see FIG. 13) for manufacturing the master using the laser exposure method described above, the planar shape of the concavity 122 (see FIG. 11) of the micro concave-convex structure 120 formed on the outer peripheral surface of the roll-shaped master 100 tends to be an elliptical shape and it is difficult to obtain a perfectly circular shape. It is thus preferable to accept that the shape of the convexity 12 of the micro concave-convex structure 11 of the cover 7 molded using the roll-shaped master 100 is a three-dimensional shape having an elliptical planar shape. This makes it possible to manufacture the micro concave-convex structure 11 including the elliptical convexity 12 with ease and high accuracy using the method for manufacturing the master using the laser exposure method.

It is preferable that, when infrared rays used in the infrared sensor are incident upon a surface of the infrared sensor cover 7 at the incidence angle θ which is greater than 0° and less than or equal to 60°, the reflectance for the infrared rays be less than or equal to 3%.

This makes it possible to further increase the detection accuracy of the infrared sensor because, even in a case where the infrared rays are obliquely incident upon the cover 7 at a large angle within a wide range of the incidence angles θ as described above, it is possible for the infrared rays to pass through the cover 7 at a high transmittance of 97% or more.

### Examples

Examples of the infrared sensor cover 7 according to the present embodiment described above will be specifically described below. Note that the following examples are examples for showing the practicability and the effects of the infrared sensor cover 7 according to the present embodiment and the present invention is not limited to the following examples.

In the following examples, a plurality of samples of the infrared sensor cover 7 described in the embodiment was fabricated and tests for evaluating the antireflection performances and the like of those samples were conducted. The following describes test conditions, evaluation methods, and evaluation results.

### [1. Test Conditions]

### (1) Method for Fabricating Infrared Sensor Cover

In each of the examples, the infrared sensor cover 7 having the micro concave-convex structure 11 formed on a surface was fabricated in the following steps.

First, the base member 110 (see FIG. 11) of the cylinder-shaped master 100 illustrated in FIG. 11 was fabricated. Subsequently, the micro concave-convex structure 120 having a shape obtained by inverting the micro concave-convex pattern of the micro concave-convex structure 11 of the cover 7 according to the example was formed on the outer peripheral surface of the base member 110 of the master 100. In detail, the resist layer on the outer peripheral surface of the base member 110 of the master 100 was exposed by the laser exposure method (see FIG. 13) described above. Subsequently, the base member 110 was etched using the developed resist layer as a mask to form the micro concave-convex structure 120 including the plurality of concavities 122. In this manner, the roll-shaped master 100 having the micro concave-convex structure 120 formed on the outer peripheral surface was manufactured.

Subsequently, the micro concave-convex structure 11 of the cover 7 was molded by a roll-to-roll method using the master 100. Specifically, the uncured resin layer 312 including an ultraviolet curable resin was laminated on a surface of the film-shaped base member 311 using the transfer device 300 as illustrated in FIG. 12 and the micro concave-convex structure 120 on the outer peripheral surface of the master 100 was transferred to the uncured resin layer 312. Note that a polyethylene terephthalate (PolyEthylene Terephthalate: PET) film having a thickness of 60 µm was used as the film-shaped base member 311. Subsequently, the resin layer 312 including an ultraviolet curable resin was cured by being irradiated with ultraviolet rays of 1000 mJ/cm² for one minute by a metal halide lamp. Thereafter, the cured resin layer 312 was released from the master 100. In this manner, a transfer object in which the micro concave-convex structure 120 of the master 100 was transferred to the resin layer 312 was fabricated.

Subsequently, the transfer object including the resin layer 312 and the film-shaped base member 311 was bonded to a surface of the base member 10 of the cover 7 using an adhesive film to fabricate the cover 7 according to the example. A polycarbonate substrate having a thickness of 2 mm was used as the base member 10 of the cover 7.

As described above, the micro concave-convex structure 11 including the plurality of convexities 12 arrayed in a hexagonal lattice shape as illustrated in FIG. 4 was molded by an imprinting method and the cover 7 provided with the micro concave-convex structure 11 on the surface of the base member 10 was fabricated.

In each of the examples described in detail below, the height H and the pitch P of the convexities 12 of the micro concave-convex structure 11 as molded above were changed. In addition, in each of comparative examples, the cover 7 including the micro concave-convex structure 11 was also fabricated as in the examples, but the height H and the pitch P of the convexities 12 of the micro concave-convex structure 11 were changed to have values different from those of the examples.

### (2) Conditions for Height H and Pitch P of Convexities 12 of Micro Concave-convex Structure 11

Table 2 and Table 3 show conditions for the heights H and the pitches P of the convexities 12 of the micro concave-convex structures 11 of the covers 7 according to the respective examples and the respective comparative examples. As shown in Table 2 and Table 3, in the respective examples and the respective comparative examples, the heights H and the pitches P of the convexities 12 were changed to have different values to mold the micro concave-convex structures 11. In any of the cases, an array of a hexagonal lattice shape illustrated in FIG. 4 was used for the disposition of the convexities 12, an elliptical shape was used as the planar shape of a convexity, and the micro concave-convex structure 11 was formed on only one surface of the cover 7.

Note that Table 2 shows Examples 1 to 8 and Comparative Example 1 in which near-infrared light the wavelength λ of which was 905 nm was used as incident light (infrared rays used in the infrared sensors) on the covers 7. Meanwhile, Table 3 shows Examples 10 to 13 and Comparative Examples 10 to 13 in which near-infrared light the wavelength λ of which was 1550 nm was used as incident light (infrared rays used in the infrared sensors) on the covers 7.

### [Table 2]

**Table 2**

| | | Example 1 | Example 2 | Example 3 | Example 4 | Example 5 | Example 6 | Example 7 | Example 8 | Comparative Example 1 |
|---|---|---|---|---|---|---|---|---|---|---|
| test condition | wavelength λ [nm] of oblique-incidence light | 905 | 905 | 905 | 905 | 905 | 905 | 905 | 905 | 905 |
| | height H [nm] of convexity | 487 | 520 | 520 | 980 | 1020 | 1040 | 810 | 570 | 250 |
| | pitch P [nm] of convexities | 300 | 350 | 400 | 350 | 400 | 450 | 230 | 500 | 230 |
| | H/λ | 0.54 | 0.57 | 0.57 | 1.08 | 1.13 | 1.15 | 0.90 | 0.63 | 0.28 |
| | P/λ | 0.33 | 0.39 | 0.44 | 0.39 | 0.44 | 0.497 | 0.25 | 0.55 | 0.25 |
| | H/P (aspect ratio) | 1.62 | 1.49 | 1.30 | 2.80 | 2.55 | 2.31 | 3.52 | 1.14 | 1.09 |
| evaluation 1 | first condition H/λ ≥ 0.5 | YES | YES | YES | YES | YES | YES | YES | YES | NO |
| | reflectance R [%] (θ = +10°) | 0.27 | 0.32 | 0.29 | 0.34 | 0.69 | 0.65 | 0.63 | 0.23 | 0.89 |
| | reflectance R [%] (θ = +40°) | 0.49 | 0.54 | 0.62 | 0.29 | 0.92 | 0.53 | 0.82 | 0.58 | 1.89 |
| | reflectance R [%] (θ = +60°) | 0.83 | 0.64 | 0.81 | 0.88 | 0.96 | 0.75 | 0.92 | 1.65 | 4.89 |
| | evaluation of antireflection effect (θ = +10°) | A | A | A | A | A | A | A | A | A |
| | evaluation of antireflection effect (θ = +40°) | A | A | A | A | A | A | A | A | B |
| | evaluation of antireflection effect (θ = +60°) | A | A | A | A | A | A | A | B | C |
| evaluation 2 | second condition P/λ ≤ 0.5 | YES | YES | YES | YES | YES | YES | YES | NO | YES |
| | evaluation of effect of reducing diffracted light | A | A | A | A | A | A | A | C | A |
| evaluation 3 | third condition H/P ≤ 3.0 | YES | YES | YES | YES | YES | YES | NO | YES | YES |
| | evaluation of releasability | A | A | A | B | A | A | C | A | A |

### [Table 3]

**Table 3**

| | | Example 10 | Example 11 | Example 12 | Example 13 | Comparative Example 10 | Comparative Example 11 | Comparative Example 12 | Comparative Example 13 |
|---|---|---|---|---|---|---|---|---|---|
| test condition | wavelength λ [nm] of oblique-incidence light | 1550 | 1550 | 1550 | 1550 | 1550 | 1550 | 1550 | 1550 |
| | height H [nm] of convexity | 980 | 1020 | 1040 | 810 | 487 | 520 | 520 | 250 |
| | pitch P [nm] of convexities | 350 | 400 | 450 | 230 | 300 | 350 | 400 | 230 |
| | H/λ | 0.63 | 0.66 | 0.67 | 0.52 | 0.31 | 0.34 | 0.34 | 0.16 |
| | P/λ | 0.23 | 0.26 | 0.29 | 0.15 | 0.19 | 0.23 | 0.26 | 0.15 |
| | H/P (aspect ratio) | 2.80 | 2.55 | 2.31 | 3.52 | 1.62 | 1.49 | 1.30 | 1.09 |
| evaluation 1 | first condition H/λ ≥ 0.5 | YES | YES | YES | YES | NO | NO | NO | NO |
| | reflectance R [%] (θ = +10°) | 0.11 | 0.79 | 0.67 | 0.82 | 0.42 | 0.23 | 0.27 | 1.89 |
| | reflectance R [%] (θ = +40°) | 1.26 | 1.41 | 1.61 | 1.23 | 1.33 | 1.66 | 1.22 | 3.20 |
| | reflectance R[%] (θ = +60°) | 1.78 | 1.82 | 1.46 | 2.11 | 4.01 | 3.10 | 2.51 | 6.80 |
| | evaluation of antireflection effect (θ = +10°) | A | A | A | A | A | A | A | B |
| | evaluation of antireflection effect (θ = +40°) | B | B | B | B | B | B | B | C |
| | evaluation of antireflection effect (θ = +60°) | B | B | B | B | C | C | C | C |
| evaluation 2 | second condition P/λ ≤ *0.5* | YES | YES | YES | YES | YES | YES | YES | YES |
| | evaluation of effect of reducing diffracted light | A | A | A | A | A | A | A | A |
| evaluation 3 | third condition H/P ≤ 3.0 | YES | YES | YES | NO | YES | YES | YES | YES |
| | evaluation of releasability | B | A | A | C | A | A | A | A |

### [2. Evaluation Methods]

In addition, Table 2 and Table 3 also show (1) the antireflection effect (reflectance R), (2) the effect of reducing diffracted light (the effect of increasing the amount of transmitted light), and (3) a result obtained by evaluating the releasability in transferring the micro concave-convex structure 11 for each of the covers 7 according to the respective examples and the respective comparative examples. The evaluation methods thereof are as follows.

### (1) Method for Measuring Reflectance R and Evaluation Criteria for Antireflection Effect

FIG. 14 is a schematic diagram illustrating the reflectance R and a method for measuring diffracted light according to an example. As illustrated in FIG. 14, near-infrared rays were incident upon a surface of the cover 7 at an incidence angle θi from a direction inclined with respect to the normal direction (Z direction) and a light amount Qr of specularly reflected light (m = 0) was measured. A semiconductor laser having the wavelength λ = 905 nm or 1550 nm was used as an incident light source. A laser power meter (S122C manufactured by Tholabs) was used as a light amount measurement apparatus.

As a procedure for measuring reflectance, first, a light amount Qi of incident light was measured with each of the covers 7 of the micro concave-convex structures 11 according to the respective examples and the respective comparative examples detached. Subsequently, incident light was incident upon the micro concave-convex structures 11 according to the respective examples and the respective comparative examples at the incidence angles θi (+10°, +40°, and +60° with respect to the normal direction) and the light amounts Qr of reflected light were measured by the laser power meter installed at positions at reflection angles θr that were the same as the incidence angles θi (θ = θi = θr).

The reflectance R (%) was then obtained using the following expression on the basis of each of the measured light amounts Qi of incident light and each of the measured light amounts Qr of reflected light. $R \left(%\right) = \left(Qr/Qi\right) \times 100$

The reflectance R is an indicator indicating antireflection performance by the micro concave-convex structure 11 on a surface of the cover 7. As the reflectance R for oblique-incidence light decreases, the antireflection performance of the micro concave-convex structure 11 for oblique-incidence light grows higher. The following criteria were used as evaluation criteria for the reflectance R (antireflection performance).
Grade A: The reflectance R was less than or equal to 1.0% (the antireflection effect for oblique-incidence light is particularly superior)
Grade B: The reflectance R was greater than 1.0% and less than or equal to 2.5% (the antireflection effect for oblique-incidence light is superior)
Grade C: The reflectance R was greater than 2.5% (the antireflection effect for oblique-incidence light is particularly inferior)

### (2) Method for Measuring Diffracted Light and Evaluation Criteria for Effect of Reducing Diffracted Light

In addition, as illustrated in FIG. 14, near-infrared rays (wavelength λ = 905 nm or 1550 nm) were incident upon a surface of the cover 7 from a direction inclined with respect to the normal direction (Z direction) and it was measured whether or not diffracted light was generated. Specifically, as a procedure for measuring diffracted light, incident light was obliquely incident upon the micro concave-convex structures 11 according to the respective examples and the respective comparative examples at the incidence angles θi (+60°, +70°, and +80° with respect to the normal direction) and the power meter was caused to perform scanning within a range of angles of -89° to +89 with respect to the normal direction, and it was measured whether or not higher-order reflected diffracted light (m = ±1, ±2, ...) other than specularly reflected light (m = 0) was generated.

The following criteria were used as evaluation criteria for the effect of reducing diffracted light (increasing the amount of transmitted light).
Grade A: No diffracted light was generated (the effect of reducing diffracted light is superior)
Grade C: Diffracted light was generated (the effect of reducing diffracted light is inferior)

### (3) Releasability Test and Evaluation Criteria

As described above, the micro concave-convex structures 11 according to the respective examples and the respective comparative examples were each transferred to the resin layer 312 (ultraviolet curable resin) on the base member 311 (PET film) by a roll-to-roll method that used the cylinder-shaped master 100 and the resin layer 312 was cured. Thereafter, the cured resin layer 312 was subjected to a test (transfer/release test) in which the cured resin layer 312 was released from the outer peripheral surface of the master 100.

As a result, the appearance of the micro concave-convex structure 11 transferred to the resin layer 312 was visually observed to evaluate (a) the presence or absence of any defect in the micro concave-convex structure 11, (b) the stability of releasing the resin layer 312 from the master 100, and (c) the stability of film tension by the roll-to-roll method. The following criteria were used as evaluation criteria for the releasability.
Grade A: No defect was caused and releasing was stable (releasability is particularly superior)
Grade B: No defect was caused, but releasing was unstable and film tension was unstable (releasability is superior)
Grade C: A defect was caused, releasing was unstable, and film tension was unstable (releasability is inferior)

### [3. Evaluation Results]

### (1) Evaluation 1 for First Condition (H/λ ≥ 0.5)

As shown in Table 2, in a case where the wavelength λ of oblique-incidence light is 905 nm, the height H of the convexity 12 of the micro concave-convex structure 11 needs to be greater than or equal to 452.5 nm, which is half of the wavelength λ, to satisfy the first condition (H/λ ≥ 0.5). In this regard, in each of Examples 1 to 8, the height H of the convexity 12 is greater than or equal to 487 nm. The height H is 0.5 times the wavelength λ or more. The first condition (H/λ ≥ 0.5) is satisfied. In contrast, in Comparative Example 1, the height H of the convexity 12 is 250 nm. The height H is less than 0.5 times the wavelength λ. The first condition (H/λ ≥ 0.5) is not satisfied.

As a result, in Comparative Example 1, as the incidence angle θi of oblique-incidence light grows larger, the reflectance R increases and the evaluation of the antireflection performance is reduced. For example, in the case of θ = +40°, the reflectance R in Comparative Example 1 is 1.89% and the antireflection performance is evaluated as Grade B. Furthermore, in the case of large-angle incidence at θ = +60°, the reflectance R in Comparative Example 1 is extremely high at 4.89% and the antireflection performance is evaluated as Grade C.

In contrast, in each of Examples 1 to 8, even when the incidence angle θi of oblique-incidence light grows larger, the reflectance R increases barely. The antireflection performance is still evaluated generally as Grade A. For example, in Examples 1 to 7, in any of cases where θ is equal to +10°, +40°, and +60°, the reflectance R is less than or equal to 1.0% and achieves Grade A. In addition, in Example 8, only in the case of θ = +60°, Grade B is achieved. However, even in this case, the reflectance R = 1.68% (Grade B) in Example 8 is considerably lower than the reflectance R = 4.89% (Grade C) in Comparative Example 1. This shows that the antireflection performance for oblique-incidence light at a large angle (θ = +60°) is significantly improved even in Example 8. As described above, in each of Examples 1 to 8, the reflectance R for the oblique-incidence light at a large angle can be kept at a value that is sufficiently lower than the reference reflectance (e.g., 3%, preferably 2.5%) described above.

In addition, as shown in Table 3, in a case where the wavelength λ of oblique-incidence light is 1550 nm, the height H of the convexity 12 needs to be greater than or equal to 775 nm, which is half of the wavelength λ, to satisfy the first condition (H/λ ≥ 0.5). In this regard, in each of Examples 10 to 13, the height H of the convexity 12 is greater than or equal to 810 nm. The height H is 0.5 times the wavelength λ or more. The first condition (H/λ≥ 0.5) is satisfied. In contrast, in each of Comparative Examples 10 to 13, the height H of the convexity 12 is less than or equal to 520 nm. The height H is less than 0.5 times the wavelength λ. The first condition (H/λ ≥ 0.5) is not satisfied.

As a result, in each of Comparative Examples 10 to 13, as the incidence angle θi of oblique-incidence light grows larger, the reflectance R increases and the evaluation of the antireflection performance is reduced. For example, in the case of large-angle incidence at θ = +60°, the reflectances R in Comparative Examples 10 to 13 are 2.51% to 6.8% and the antireflection performances are evaluated as Grade C. In particular, Comparative Example 13 offers an extremely small value H/λ = 0.16. Therefore, even in the case of θ = +40°, the reflectance R is as high as 3.2% (Grade C). Furthermore, in the case of large-angle incidence at θ = +60°, the reflectance R is significantly high at 6.8% (Grade C) and the antireflection performance is significantly reduced.

In contrast, in each of Examples 10 to 13, as the incidence angle θi of oblique-incidence light grows larger, the reflectance R slightly increases, but the antireflection performance is evaluated as Grade A or Grade B. For example, although θ is equal to +60°, the reflectance R in any of Example 10 to 13 is less than or equal to 2.11% (Grade B) and is considerably smaller than the reflectance R = 2.51 to 6.8% (Grade C) in any of Comparative Examples 10 to 14. As described above, in each of Examples 10 to 13, the reflectance R for the oblique-incidence light at a large angle can also be kept at a value that is sufficiently lower than the reference reflectance (e.g., 3%, preferably 2.5%) described above.

The comparison results above prove that the satisfaction of the first condition (H/λ ≥ 0.5) by the height H of the convexity 12 and the wavelength λ makes it possible to increase the antireflection effect for near-infrared oblique-incidence light within a wide range of the incidence angles θ. In particular, it is proved that the antireflection effect for oblique-incidence light, for example, at a large angle of about 60° can be significantly increased. Simply satisfying the first condition (H/λ ≥ 0.5) thus makes it possible to increase the transmittance for near-infrared oblique-incidence light passing through the cover 7 and increase the detection accuracy of the infrared sensor.

### (2) Evaluation 2 for Second Condition (P/λ ≤ 0.5)

As shown in Table 2, in a case where the wavelength λ of oblique-incidence light is 905 nm, the pitch P of the convexities 12 of the micro concave-convex structure 11 needs to be less than or equal to 452.5 nm, which is half of the wavelength λ, to satisfy the second condition (P/λ ≤ 0.5). In this regard, in each of Examples 1 to 7, the pitch P of the convexities 12 is less than or equal to 450 nm. The pitch P is 0.5 times the wavelength λ or less. The second condition (P/λ ≤ 0.5) is satisfied. In contrast, in Example 8, the pitch P of the convexities 12 is 500 nm. The pitch P is 0.5 times the wavelength λ or more. The second condition (P/λ ≤ 0.5) is not satisfied.

As a result, in Example 8, as illustrated in FIG. 14, reflected diffracted light (m = ±1 and ±2) was generated on a surface of the convexity 12 of the micro concave-convex structure 11. Therefore, in Example 8, oblique-incidence light incident upon the micro concave-convex structure 11 was bent and the straight-propagating properties of the oblique-incidence light were reduced. The transmittance for oblique-incidence light passing through the cover 7 was reduced. As a result, in Example 8, the effect of reducing diffracted light was evaluated as Grade C.

In contrast, in each of Examples 1 to 7, no reflected diffracted light (m = ±1 and ±2) was generated on a surface of the convexity 12 of the micro concave-convex structure 11. In each of Examples 1 to 7, the straight-propagating properties of oblique-incidence light incident upon the micro concave-convex structure 11 were not reduced. The transmittance for oblique-incidence light passing through the cover 7 was not reduced. As a result, in each of Examples 1 to 7, the effect of reducing diffracted light was superior and was evaluated as Grade A.

The comparison results above prove that the satisfaction of the second condition (P/λ ≤ 0.5) by the pitch P of the convexities 12 and the wavelength λ makes it possible to increase the effect of reducing diffracted light for near-infrared oblique-incidence light within a wide range of the incidence angles θ. Simply satisfying the second condition (P/λ ≤ 0.5) thus makes it possible to further increase the transmittance for near-infrared oblique-incidence light passing through the cover 7 and further increase the detection accuracy of the infrared sensor.

### (3) Evaluation 3 for Third Condition (H/P ≤ 3)

As shown in Table 2 and Table 3, in each of Examples 1 to 6 and 8 and Examples 10 to 12, the ratio (i.e., aspect ratio = H/P) of the height H to the pitch P of the convexities 12 is less than or equal to 2.8 and the third condition (H/P ≤ 3) is satisfied. In contrast, in any of Example 7 and Example 13, the aspect ratio is 3.52 and the third condition (H/P ≤ 3) is not satisfied.

As a result, in each of Example 7 and Example 13, when imprinting for transferring the micro concave-convex structure 11 was performed by a roll-to-roll method using the roll-shaped master 100, a defect was caused in the convexity 12 of the micro concave-convex structure 11, releasing was unstable, and film tension was unstable. The releasability was therefore evaluated as Grade C.

In contrast, in each of Examples 1 to 3, 5, 6, and 8 and Examples 11 and 12, when the imprinting was performed, no defect was caused in the convexity 12 of the micro concave-convex structure 11 and both releasing and film tension were stable. The releasability was therefore evaluated as Grade A. In addition, in each of Example 4 and Example 10, when the imprinting was performed, no defect was caused in the convexity 12 of the micro concave-convex structure 11, but both releasing and film tension were slightly unstable. The releasability was therefore evaluated as Grade B.

The comparison results above prove that the satisfaction of the third condition (H/P ≤ 3) by the ratio (i.e., aspect ratio = H/P) of the height H to the pitch P of the convexities 12 makes it possible to increase the releasability at the time of imprinting and prevent the convexity 12 of the micro concave-convex structure 11 from having any defect. Furthermore, it is proved that the satisfaction of the condition (H/P ≤ 2.8) that the aspect ratio is less than or equal to 2.8 as in Examples 1 to 3, 5, 6, and 8 and Examples 11 and 12 makes it possible to stabilize even releasing at the time of imprinting and film tension and further increase the releasability in addition to the effect of preventing the convexity 12 from having any defect at the time of imprinting.

The embodiment of the present invention has been described so far with reference to the appended drawings, but it goes without saying that the present invention is not limited to the embodiment. It is apparent that a person skilled in the art may find various alterations and modifications within the scope of the claims and it should be understood that they will naturally come under the technical scope of the present invention.

### Reference Signs List

- 1: optical distance measurement apparatus (infrared sensor)
- 2: light irradiation device
- 3: light detection device
- 4: controller
- 5: distance measurement target area
- 6: measurement target
- 7: infrared sensor cover
- 10: base member
- 11: micro concave-convex structure
- 12: convexity
- 13: concavity
- 100: master
- 110: base member
- 120: micro concave-convex structure
- 122: concavity
- 123: convexity
- 300: transfer device
- 311: base member
- 312: resin layer

## Claims

1. An infrared sensor cover that covers an infrared sensor configured to measure distance to a measurement target using an infrared ray, the infrared sensor cover comprising:
a base member; and
a micro concave-convex structure that is provided on at least one surface of the base member, the micro concave-convex structure including a plurality of convexities disposed at pitch P less than or equal to a wavelength λ of the infrared ray, wherein
the infrared sensor cover is disposed on the infrared sensor to allow the infrared ray to be incident upon the infrared sensor cover from a direction inclined with respect to the surface of the infrared sensor cover, and
a ratio (H/λ) of height H of each of the convexities to the wavelength λ is greater than or equal to 0.5.

2. The infrared sensor cover according to claim 1, wherein a ratio (P/λ) of the pitch P of the convexities to the wavelength λ is less than or equal to 0.5.

3. The infrared sensor cover according to claim 1, wherein a ratio (H/P) of the height H to the pitch P of the convexities is less than or equal to 3.

4. The infrared sensor cover according to claim 1, wherein the infrared ray is a near-infrared ray the wavelength λ of which is greater than or equal to 800 nm and less than or equal to 2500 nm.

5. The infrared sensor cover according to claim 1, wherein a shape of the convexity is substantially an elliptical-cone shape, an elliptical-cone frustum shape, or a bell shape or a dome shape a planar shape of which is an elliptical shape.

6. The infrared sensor cover according to claim 1, wherein, when the infrared ray is incident upon the surface of the infrared sensor cover at an incidence angle of greater than 0° and less than or equal to 60°, reflectance for the infrared ray is less than or equal to 3%.

7. An infrared sensor comprising:
the infrared sensor cover according to any one of claims 1 to 6;
a light irradiation device configured to irradiate a measurement target with infrared laser light through the infrared sensor cover; and
a light detection device configured to detect, through the infrared sensor cover, reflected light of the infrared laser light reflected by the measurement target.
